# EUROPÄISCHE PATENTSCHRIFT

(11) **EP 4 143 360 B1**
(45) Veröffentlichungstag und Bekanntmachung des Hinweises auf die Patenterteilung: **28.01.2026**
(21) Anmeldenummer: 21737570.8
(22) Anmeldetag: 17.06.2021
(51) Int. Cl.: C23C 14/06, C23C 14/34, C23C 14/35, H01J 37/32, H01J 37/34

(54) **VERFAHREN UND VORRICHTUNG ZUM AUFBRINGEN EINER BESCHICHTUNG SOWIE BESCHICHTETER KÖRPER**
METHOD AND DEVICE FOR APPLYING A COATING, AND COATED ITEM
PROCÉDÉ ET DISPOSITIF POUR APPLIQUER UN REVÊTEMENT ET CORPS REVÊTU

(30) Priorität: 18.06.2020 DE 102020116157
(43) Veröffentlichungstag der Anmeldung: 08.03.2023
(73) Patentinhaber: CemeCon AG, 52146 Würselen (DE)
(72) Erfinder: KÖLKER, Werner, 52134 Herzogenrath (DE); BOLZ, Stephan, 52072 Aachen (DE); LEMMER, Oliver, 52066 Aachen (DE)
(74) Vertreter: Kalkoff & Partner Patentanwälte mbB
(86) Internationale Anmeldenummer: PCT/EP2021/066499
(87) Internationale Veröffentlichungsnummer: WO 2021/255201

(56) Entgegenhaltungen:
- EP-A1- 2 784 799
- EP-A2- 2 761 050
- US-A1- 2007 092 761
- CEMIN FELIPE ET AL: "Tuning high power impulse magnetron sputtering discharge and substrate bias conditions to reduce the intrinsic stress of TiN thin films", THIN SOLID FILMS, ELSEVIER, AMSTERDAM, NL, vol. 688, 30 May 2019 (2019-05-30), XP085819331, ISSN: 0040-6090, [retrieved on 20190530], DOI: 10.1016/J.TSF.2019.05.054
- NEDFORS NILS ET AL: "Effect of synchronized bias in the deposition of TiB 2 thin films using high power impulse magnetron sputtering ARTICLES YOU MAY BE INTERESTED IN Tutorial: Reactive high power impulse magnetron sputtering Effect of synchronized bias in the deposition of TiB 2 thin films using high power impulse magn", J. VAC. SCI. TECHNOL. A J. VAC. SCI. TECHNOL. A JOURNAL OF APPLIED PHYSICS JOURNAL OF VACUUM SCIENCE & TECHNOLOGY A JOURNAL OF VACUUM SCIENCE & TECHNOLOGY A, 1 January 2018 (2018-01-01), pages 31510 - 31510, XP055880003, Retrieved from the Internet <URL:https://avs.scitation.org/doi/pdf/10.1116/1.5003194> [retrieved on 20220117]

## Beschreibung

Die Erfindung betrifft Verfahren und Vorrichtungen zum Aufbringen einer Schicht auf einen Körper. Insbesondere betrifft die Erfindung Beschichtungen, die durch Kathodenzerstäubung erzeugt werden.

Es ist bekannt, Körper oder Teile von Körpern mit einer Oberflächenbeschichtung zur Verbesserung der mechanischen oder chemischen Eigenschaften zu versehen. Insbesondere für Werkzeuge und Bauteile, die einem Verschleiß unterliegen, ist es bekannt, Funktionsflächen mit Beschichtungen zu versehen. Als Beschichtungen sind insbesondere Hartstoffschichten bekannt.

Zur Bildung von dünnen Beschichtungen sind neben CVD-Verfahren besonders PVD-Beschichtungsverfahren bekannt, insbesondere die Verfahren der Kathodenzerstäubung.

Die WO 2014 / 063 676 A1 beschreibt ein Bauteil mit einer Beschichtung aus Chrom, Stickstoff und Kohlenstoff, die in einem PVD-Verfahren mit Lichtbogenverdampfung aufgebracht wird. In einer Vakuumkammer wird ein Edelgas eingelassen und zunächst unter einer Biasspannung von -800 bis -1200 V ein Ionenätzen durchgeführt. Danach wird die Biasspannung auf einen niedrigen Wert eingestellt und eine Schicht aufgebracht. Als Edelgas kann Argon verwendet werden oder Neon, das zu geringeren Eigenspannungen führt als eingelagertes Argon.

Die WO 2013/045454 A2 beschreibt ein Verfahren und eine Vorrichtung zur Beschichtung von Substraten. In einer Vakuumkammer werden Magnetronkathoden mit Sputter-Targets angeordnet. Einige der Kathoden sind HIPIMS-Kathoden, d.h. sie werden mittels einer HIPIMS-Leistungsversorgung mit elektrischer Leistung in Form von Spannungspulsen betrieben. An die zu beschichtenden Substrate wird eine Bias-Spannung angelegt, die in bevorzugten Ausführungsformen Pulse aufweist, die mit den Spannungspulsen an einer Kathode so synchronisiert sind, dass sie während zumindest eines Teils einer Periode anliegen, die charakterisiert ist durch eine hohe Anzahl an Metallionen, die durch den HIPIMS-Puls an der Kathode erzeugt werden. Im Vergleich mit länger anliegenden Pulsen oder einem durchgehenden Gleichspannungs-Bias werden so geringere Mengen des Prozessgases, bspw. Argon, in der Schicht eingeschlossen.

US 2008/0135401 A1 beschreibt eine Vorrichtung zum Sputtern eines Targets mit einer Stromdichte auf einer Magnetronkathode zwischen 0,1 und 10 A/cm² um eine Beschichtung auf einem Substrat zu erzeugen. Die Vorrichtung umfasst eine Leistungsversorgung, die mit dem Magnetron verbunden ist, sowie eine Kapazität, die mit der Leistungsversorgung verbunden ist. Ein erster Schalter verbindet die Leistungsversorgung mit dem Magnetron, um dieses in Übereinstimmung mit einem ersten Puls zu laden. Eine Bias-Vorrichtung ist mit dem Substrat verbunden um ein Substratbias vorzugeben. Ein Bias kann bspw. als RF-Leistung in einem gepulsten Modus angelegt und mit HIPIMS-Pulsen synchronisiert sein. Eine Synchronisierungsvorrichtung synchronisiert eine Frequenz und eine zeitliche Verzögerung des ersten Pulses.

EP 3 457 428 A1 beschreibt ein Verfahren und eine Vorrichtung zur Bearbeitung von Halbleiter-Substraten. Ein Puls-Synchronisationscontroller ist zwischen einem Puls-RF-Bias-Generator und einem HIPIMS-Generator verbunden. Ein erstes Timing-Signal wird vom Puls-Synchronisationscontroller zum Puls-RF-Bias-Generator und zum HIPIMS-Generator gesendet. Ein Sputtertarget und eine RF-Elektrode an einer Substrataufnahme werden basierend auf dem ersten Timing-Signal mit Energie beaufschlagt und am Ende des Timing-Signals energielos gemacht. Ein zweites Timing-Signal wird vom Puls-Synchronisationscontroller zum Puls-RF-Bias-Generator gesendet und die Elektrode wird mit Energie beaufschlagt und energielos gemacht, ohne dass das Target basierend auf dem zweiten Timing-Signal mit Energie beaufschlagt wird.

Die EP 2 784 799 A1 beschreibt dichte, harte Beschichtungen von Substraten durch HIPIMS. In einer Vakuumkammer sind eine erste Magnetronkathode mit einem Sputtertarget aus einer ersten Materialzusammensetzung und eine zweite Magnetronkathode mit einem Sputtertarget aus einer zweiten Materialzusammensetzung angeordnet. Die erste Materialzusammensetzung enthält als vorherrschendes Metallelement ein Verarbeitungsmetallelement enthält, das aus Hf, Ta, Zr, W, Nb und Mo ausgewählt ist. Die zweite Materialzusammensetzung enthält überwiegend Kohlenstoff oder ein oder mehrere Metalle mit einer geringeren Atommasse als das Verarbeitungsmetallelement. Um Beschichtungen mit verbesserten Eigenschaften zu erhalten, wird den Kathoden elektrische Leistung so zugeführt, dass die Targets gesputtert werden, wobei der ersten Kathode elektrische Leistung als gepulste elektrische Leistung als HIPIMS mit einer ersten Spitzenstromdichte zugeführt wird und der zweiten Kathode elektrische Gleichstromleistung mit einer konstanten zweiten Stromdichte oder als zeitlich veränderliche elektrische Leistung mit einer zweiten Spitzenstromdichte zugeführt wird, die niedriger als die erste Spitzenstromdichte ist. Während des Abscheidungsprozesses wird an das Substrat eine Vorspannung angelegt, die aus Vorspannungsimpulsen besteht, die mit den an die erste Kathode angelegten Impulsen synchronisiert sind und für eine kürzere Dauer als die Impulse an der ersten Kathode angelegt werden. Auf diese Weise kann ein beschichteter Körper mit einem Substrat und einer Beschichtung gebildet werden, die Oxide, Nitride oder Oxinitride von Kohlenstoff oder Metallen aus den Gruppen IVA - VIA des Periodensystems und mindestens ein Prozessmetallelement aus Hf, Ta, W, Zr, Nb und Mo in einer Atomkonzentration von 1 - 18 Atom-% enthält. Die Schicht enthält eine Prozessgaskonzentration von 0,3 at.-% oder weniger.

US 2007092761 A1 offenbart eine verschleißfeste Struktur. Ein beschichteter Körper ist mit einer harten Beschichtung versehen, der eine hohe Haftfähigkeit und eine ausgezeichnete Verschleißfestigkeit aufweist. Die Oberfläche eines Basiskörpers ist mit mindestens einer Schicht versehen aus einem oder mehreren von Nitriden, Nitrooxiden, Carbonitriden und Carbonitrooxiden einschließlich mindestens Ti und Al, die 0. 01-1 Masse-% eines oder mehrerer Inertgaselemente ausgewählt aus He, Ne, Ar, Xe, Kr und Rn enthält.

CEMIN FELIPE ET AL, "Tuning high power impulse magnetron sputtering discharge and substrate bias conditions to reduce the intrinsic stress of TiN thin films", THIN SOLID FILMS, ELSEVIER, AMSTERDAM, NL, vol. 688, ISSN 0040-6090 berichtet über eine Abstimmung der Entladung beim Hochleistungsimpuls-Magnetronsputtern und der Substratvorspannung zur Verringerung der Eigenspannung von TiN-Dünnschichten. Die Strategie basiert auf der Optimierung der Prozessentladungsparameter, die zu HiPIMS-Entladungen führen, die weniger mehrfach geladene energetische Metallionen enthalten. Dies wird mit einer gepulsten Substratvorspannung kombiniert, die mit dem HiPIMS-Puls synchronisiert ist, um die chemische Beschaffenheit der einfallenden Ionen zu steuern, d. h. Inertgas gegenüber Metallionen.

Es kann als Aufgabe angesehen werden, ein Verfahren und eine Vorrichtung zum Aufbringen einer Schicht auf einen Körper vorzuschlagen, mit denen gezielt besonders günstige Schichteigenschaften erzielbar sind.

Die Aufgabe wird gelöst durch ein Verfahren gemäß Anspruch 1 und eine Vorrichtung gemäß Anspruch 14. Abhängige Ansprüche beziehen sich auf vorteilhafte Ausführungsformen der Erfindung.

Die Erfinder sind von der Überlegung ausgegangen, dass bei der Erzeugung von Schichten mittels Kathoden-Zerstäubung unter Anlegung gepulster Spannungen an der Kathode die Schichtzusammensetzung durch den zeitlichen Verlauf der Bias-Spannung unterschiedlich vorgebbar ist. Je nachdem, ob die Bias-Spannung als Gleichspannung oder gepulste Spannung angelegt wird, und im Fall einer gepulsten Spannung in Abhängigkeit von der zeitlichen Synchronisation mit den Pulsen an der Kathode, können gezielt die zu unterschiedlichen Zeitpunkten im Plasma vorherrschenden Bestandteile ausgewählt und zur Bildung der Schicht genutzt werden. Insbesondere wenn sich, wie beim HIPIMS-Verfahren, der zeitliche Verlauf der im Plasma vorhandenen Gasionen von dem der Metallionen unterscheidet, kann so durch den Zeitverlauf der Bias-Spannung der Anteil der Gasionen relativ zu den Metallionen gezielt eingestellt werden.

Im Gegensatz zur bekannten Lehre, eine gewünschte Zusammensetzung der Schicht durch einen geeigneten, über die Beschichtungsdauer gleichbleibenden Zeitverlauf der Bias-Spannung zu erreichen, schlagen die Erfinder vor, durch eine Variation des Zeitverlaufs der Bias-Spannung während der Beschichtungsdauer gezielt unterschiedliche Zusammensetzungen der Schicht über die Schichtdicke zu erzielen. Denn konträr zur vorherigen Auffassung, dass Gasionen in der Schicht generell unerwünscht und stets zu minimieren seien, haben die Erfinder erkannt, dass - je nach der gewünschten Anwendung des Körpers, der Schichtstruktur, den generellen Schichteigenschaften, der Art des Substrats, etc. - ein Anteil an Gasionen in bestimmten Bereichen der Schicht, bspw. je nach vorliegendem Fall an der Schichtoberfläche, im Interface-Bereich oder in mittleren Bereichen der Schicht, durchaus vorteilhaft sein kann, sofern der Anteil über die Schichtdicke variiert und gezielt einstellbar ist.

Dabei handelt es sich bei den betrachteten Gasionen vorrangig um Ionen von als Prozessgas in der Vakuumkammer genutzten Edelgasen, insbesondere Argon.

So hat sich gezeigt, dass bei vergleichsweise hohen Argon-Anteilen Schichten erzielbar sind mit sehr hoher Härte und hohen Eigenspannungen, d.h. harte und spröde Schichten, während Schichten ohne Argon oder mit geringerem Anteil im Vergleich eher duktil sind. Überraschend hat sich gezeigt, dass für einige Anwendungen, bspw. die Hartbearbeitung, Schichten, die zumindest an der Schichtoberfläche hohe Eigenspannungen aufweisen, besonders gute Ergebnisse erzielen, bspw. eine hohe Zerspanleistung. Andererseits können Schichtanteile, die aufgrund eines geringeren Anteils an Argon eher duktil sind, sehr günstige Eigenschaften aufweisen, bspw. im Interface-Bereich, z.B. zur Erzielung einer guten Haftung am Substrat oder - je nach Einsatzzweck des Körpers, bspw. als Werkzeug - auch im Bereich der Schichtoberfläche, bspw. hinsichtlich tribologischer Eigenschaften oder für das Einlaufverhalten.

Um eine gezielte Einstellung des gewünschten Schichtaufbaus und der daraus resultierenden Eigenschaften zu ermöglichen, sieht das erfindungsgemäße Verfahren zum Aufbringen einer Schicht auf einen Körper vor, dass der Körper in einer Vakuumkammer angeordnet und unter Zuführung eines Prozessgases, bspw. eines Edelgases, bevorzugt Argon, durch Betrieb einer oder mehrerer Kathoden ein Plasma erzeugt und mindestens ein Target zerstäubt wird. Bei den Kathoden handelt es sich bevorzugt um Magnetron-Kathoden, insbesondere unbalancierte Magnetrons, die mit Targets aus einem Target-Material, bevorzugt aus einem oder mehreren Metallen, versehen sind, das zerstäubt wird, so dass das Plasma Gasionen und Metallionen aufweist (Magnetronsputtern).

Erfindungsgemäß wird mindestens eine Kathode nicht mit konstanter Spannung, sondern durch eine gepulste Kathodenspannung betrieben, die zeitlich beabstandete Kathodenpulse aufweist. Bevorzugt erfolgt der Betrieb einer oder mehrerer Kathoden gemäß dem HIPIMS-Verfahren (High Power Impulse Magnetron Sputtering), bei dem kurze Kathodenpulse mit hoher Spannung angelegt und sehr hohe Peak-Leistungen erreicht werden. Unter dem HIPIMS-Verfahren wird hier insbesondere ein Betrieb innerhalb der nachfolgend im Rahmen möglicher Ausführungsbeispiele genannten Parameter-Bereiche verstanden.

Während mindestens eines Teils der Beschichtungsdauer wird eine Bias-Spannung an den zu beschichtenden Körper angelegt, so dass Ladungsträger des Plasmas in Richtung des Körpers beschleunigt werden und sich auf dessen Oberfläche als Schicht anlagern. Dabei ist das erfindungsgemäße Verfahren dadurch gekennzeichnet, dass der Zeitverlauf der Bias-Spannung während der Beschichtungsdauer variiert.

Bei dem Zeitverlauf der Bias-Spannung kann es sich - im Fall einer Gleichspannung - zumindest abschnittsweise um einen konstanten Zeitverlauf handeln oder um einen veränderlichen Zeitverlauf, insbesondere einen gepulsten Zeitverlauf. Die erfindungsgemäße Variation des Zeitverlaufs während der Beschichtungsdauer kann im Fall eines durchgehend zeitlich veränderlichen, periodischen Zeitverlaufs eine Änderung der Frequenz oder Phasenlage umfassen. Erfindungsgemäß umfasst die Variation des Zeitverlaufs eine zu verschiedenen Zeitpunkten oder Intervallen während der Beschichtungsdauer unterschiedliche Dauer und/oder zeitliche Synchronisation mit den Kathodenpulsen. Durch den Zeitverlauf der Bias-Spannung kann wie erläutert die Zusammensetzung der Schicht beeinflusst werden: Während bspw. bei konstanter Bias-Spannung (DC) sämtliche Ionen des Plasmas gleichmäßig in Richtung auf den Körper beschleunigt werden, können durch eine gepulste Bias-Spannung, deren Bias-Pulse zeitlich mit den Kathodenpulsen synchronisiert sind, d. h. mit gleicher Frequenz und fester Phasenbeziehung angelegt werde, durch Dauer und zeitliche Lage des Pulses jeweils die zum so ausgewählten Zeitpunkt im Plasma vorhandenen Spezies von Ionen ausgewählt und in Richtung des Körpers beschleunigt werden.

Dementsprechend kann eine Bias-Spannung mit während der Beschichtungsdauer variablem Zeitverlauf abschnittsweise oder durchgehend einen gepulsten Verlauf aufweisen, wobei die Synchronisation mit den Kathodenpulsen über die Beschichtungsdauer variieren kann. Ebenso kann der Zeitverlauf der Bias-Spannung in einem oder mehreren zeitlichen Abschnitten ein Gleichspannungsverlauf sein, während in anderen Abschnitten ein gepulster Zeitverlauf angewendet wird.

Erfindungsgemäß ist der Zeitverlauf der Bias-Spannung mindestens während eines Teils der Beschichtungsdauer gepulst, d.h. die Bias-Spannung umfasst Bias-Pulse, die mit den Kathodenpulsen synchronisiert sind, d. h. mit gleicher (bzw. alternativ vielfacher) Frequenz und fester Phasenbeziehung angelegt werden. Die Pulse sind bevorzugt Gleichspannungspulse, d. h. während der Pulsdauer liegt bevorzugt eine mindestens im Wesentlichen konstante Bias-Spannung an. Die Zeit, relativ zu den Kathodenpulsen, zu der die Bias-Pulse wirksam sind, können somit durch die jeweilige Pulsdauer und durch die zeitliche Lage relativ zu den Kathodenpulsen charakterisiert werden (d.h. die Zeitdifferenz des jeweiligen Pulsbeginns vor bzw. nach dem Beginn eines Kathodenpulses, wobei die Zeitdifferenz ggfs. auch Null sein kann). Die erfindungsgemäße Variation des Zeitverlaufs der Bias-Spannung während der Beschichtungsdauer erfolgt in der Form einer Änderung der Dauer und/oder der Synchronisation (d.h. bspw. Zeitdifferenz) der Bias-Pulse gegenüber den Kathodenpulsen, wobei die Änderung von Dauer und/oder Synchronisation sprunghaft oder kontinuierlich sein kann, bspw. in Form eines Rampenverlaufs.

In jedem Fall ergeben sich aufgrund der Variation des Zeitverlaufs der Bias-Spannung während unterschiedlicher Zeitpunkte oder Intervalle während der Beschichtungsdauer unterschiedliche Bedingungen für das Schichtwachstum, so dass sich bei fortschreitendem Schichtwachstum Schichten ergeben, deren Struktur und/oder Zusammensetzung über die Schichtdicke variiert. So ist es möglich, in verschiedenen Bereichen der Schicht jeweils speziell geeignete Eigenschaften zu erzielen, bspw. eine gute Haftung am Substrat, eine harte oder glatte Oberfläche, etc.

Die erfindungsgemäße Vorrichtung ist geeignet zur Ausführung des erfindungsgemäßen Verfahrens. Sie umfasst eine Vakuumkammer mit einer Aufnahme für den Körper, einer Prozessgaszuführung und einer Kathode mit einem Target. Die Kathode ist an eine Kathoden-Leistungsversorgung und der Körper bzw. dessen Aufnahme an eine steuerbare Bias-Leistungsversorgung angeschlossen. Mittels der Kathoden-Leistungsversorgung, bevorzugt eine HIPIMS-Leistungsversorgung, wird die Kathodenspannung mit den Kathodenpulsen erzeugt und mittels der Bias-Leistungsversorgung eine Bias-Spannung. Dabei ist eine Steuerung vorgesehen, mit der die Bias-Leistungsversorgung so angesteuert wird, dass der Zeitverlauf der Bias-Spannung während der Beschichtungsdauer variiert. Erfindungsgemäß variiert der Zeitverlauf der Bias-Spannung während der Beschichtungsdauer in der Form einer Änderung der Dauer und/oder der Synchronisation (d.h. bspw. Zeitdifferenz) der Bias-Pulse gegenüber den Kathodenpulsen,

Die Steuerung kann insbesondere eine programmierbare Steuerung sein, mit der bevorzugt neben der Bias-Leistungsversorgung auch weitere Funktionen der Beschichtungsvorrichtung gemäß einem Beschichtungsprogramm zeitabhängig gesteuert werden, insbesondere elektrische Leistungsversorgungen verschiedener Kathoden sowie die Zuführung von Prozess- und/oder Reaktivgasen.

Ein beschichteter Körper kann bspw. mittels des erfindungsgemäßen Verfahrens und/oder der erfindungsgemäßen Vorrichtung hergestellt werden. Der Körper umfasst ein Substrat, bei dem es sich bspw. um einen Grundkörper bspw. aus Stahl, insbesondere HSS oder CrMo-Stahl, Hartmetall, keramischem Material oder cBN (kubisches Bornitrid) handeln kann. Das Substrat kann bspw. ein Werkzeug sein, insbesondere zur Zerspanung, wie z.B. ein Bohrer, ein Fräser, eine Wendeschneidplatte, ein Stech- oder Stanzwerkzeug, etc.

Auf der Oberfläche des Substrats ist eine mittels Kathodenzerstäubung aufgebrachte Schicht aus einem Schichtmaterial angeordnet. Das erfindungsgemäße Schichtmaterial umfasst mindestens ein Element aus einer ersten Gruppe umfassend Aluminium (Al), Silizium (Si), Yttrium (Y) und Elemente der Gruppen 4 - 6 des Periodensystems nach IUPAC (1988) sowie mindestens ein Element aus einer zweiten Gruppe umfassend Stickstoff (N), Sauerstoff (O), Kohlenstoff (C) und Bor (B). Die Auswahl von Elementen der ersten und zweiten Gruppe kann als Materialsystem bezeichnet werden. Bevorzugte Materialsysteme umfassen vor allem Stickstoff sowie ein oder mehrere Elemente der ersten Gruppe, insbesondere Titan (Ti), Aluminium (Al), Silizium (Si) und/oder Chrom (Cr). Materialsysteme werden hier durch Nennung der jeweiligen Elemente mit Bindestrichen dargestellt, d.h. ohne Angabe der chemischen Verbindungen. Besonders bevorzugte Schichtsysteme sind Aluminium-Titan-Nitrid (Al-Ti-N), Titannitrid (Ti-N), Titan-Aluminium-Silizium-Nitrid (Ti-Al-Si-N), Titan-Aluminium-Chrom-Silizium-Nitrid (Ti-Al-Cr-Si-N), Titan-Borid (TiB₂), Titan-Carbonitrid (Ti-C-N), Titan-Aluminium-Carbonitrid (Al-Ti-C-N), Chrom-Nitrid (Cr-N), Zirkon-Nitrid (Zr-N) und Titan-Carbid (Ti-C). Dabei ist es bevorzugt, dass die angegebenen Elemente jedes Materialsystems in der Reihenfolge Ihrer relativen Atommengen gelistet sind.

Das Schichtmaterial umfasst auch Anteile eines Edelgases, bevorzugt Argon. Dabei variiert bei dem erfindungsgemäßen Körper die Konzentration des Edelgases in der Schicht über die Schichtdicke, d. h. an unterschiedlichen Stellen der Schicht, abhängig vom Abstand der jeweils betrachteten Stelle der Schicht von der Schichtoberfläche bzw. dem Substrat, ergeben sich unterschiedliche Konzentrationen des Edelgases innerhalb der Schicht.

Bei dem Edelgas handelt es sich um das beim Aufbringen der Schicht mittels Kathodenzerstäubung verwendete Prozessgas, bevorzugt Argon. Wie vorstehend beschrieben ist eine Steuerung des Prozessgas-Anteils in der Schicht insbesondere durch geeignete Wahl des Zeitverlaufs der Bias-Spannung möglich, so dass der gewünschte Konzentrationsverlauf über die Schichtdicke gezielt einstellbar ist.

Vorteilhafte Weiterbildung des erfindungsgemäßen Verfahrens betreffen insbesondere die Art der Variation des Zeitverlaufs der Bias-Spannung. Vorteilhafterweise ist es wie erläutert bei geeigneter Anwendung zu erreichen, dass der Anteil des Prozessgases in der Schicht abhängig ist vom Zeitverlauf der Bias-Spannung. Durch Variation des Zeitverlaufs während der Beschichtungsdauer kann so der angestrebte über die Schichtdicke variierende Anteil an Prozessgas in der Schicht erzielt werden.

Im Rahmen des erfindungsgemäßen Verfahrens und der erfindungsgemäßen Vorrichtung sind verschiedene Ausführungsformen möglich. So weist bevorzugt die Bias-Spannung mindestens während eines ersten Zeitintervalls innerhalb der Beschichtungsdauer einen pulsförmigen Zeitverlauf auf, d. h. sie umfasst Spannungspulse, die hier als "Bias-Pulse" bezeichnet werden. Die Bias-Pulse sind bevorzugt mit den Kathodenpulsen synchronisiert, d.h. weisen gleiche Frequenz auf (oder alternativ ist eine der Frequenzen ein Vielfaches der anderen Frequenz, was ebenfalls eine Synchronisation darstellt). Zwar ist auch eine Synchronisation möglich, bei der Bias-Pulse und Kathodenpulse stets gleichzeitig beginnen, ebenso ist ein zeitlicher Vorlauf der Bias-Pulse möglich, bevorzugt treten aber die Bias-Pulse gegenüber den Kathodenpulsen um eine Verzögerungszeit verzögert auf, d.h. ihr Beginn ist dem Beginn der Kathodenpulse zeitlich nachgelagert. Die Verzögerungszeit kann bspw. im Bereich von 5 - 150 µs liegen und wird gemäß der jeweils bevorzugten Ionen gewählt. Die Dauer der Bias-Pulse liegt bspw. im Bereich von 30 - 150µs, bevorzugt 50 - 100µs.

Während eines weiteren Zeitintervalls, das während der Beschichtungsdauer zeitlich vor oder nach dem ersten Zeitintervall liegen kann, ggfs. auch mit zeitlichem Abstand dazwischen, hat die Bias-Spannung dann bevorzugt einen vom ersten Zeitintervall abweichenden Zeitverlauf. Dieser kann bspw. ein Pulsverlauf wie im ersten Zeitintervall sein, allerdings mit abweichender Phasenbeziehung, insbesondere abweichender Verzögerungszeit. Ebenso kann der abweichende Zeitverlauf im weiteren Zeitintervall auch eine konstante Gleichspannung sein (DC-Bias). Durch eine DC-Biasspannung werden unterschiedslos alle Ionen des Plasmas in Richtung auf das Substrat beschleunigt und es kommt zur Bildung einer Beschichtung mit relativ hohem Anteil an Prozessgas, vergleichen mit einer gepulsten Bias-Spannung, bei der durch geeignete Synchronisation mit den Kathodenpulsen eine selektive Auswahl an Ionen möglich ist, so dass bspw. gezielt ein erhöhter Anteil an Metallionen ausgewählt werden kann.

Gemäß einer vorteilhaften Ausführung umfasst der Zeitverlauf der Bias-Spannung während des ersten Zeitintervalls Bias-Pulse, die mit den Kathodenpulsen synchronisiert sind, und gegenüber den Kathodenpulsen um eine erste Verzögerungszeit verzögert auftreten, und während eines zweiten Zeitintervalls Bias-Pulse, die ebenfalls mit den Kathodenpulsen synchronisiert sind, dabei allerdings gegenüber den Kathodenpulsen um eine zweite, von der ersten abweichende Verzögerungszeit verzögert auftreten. Das zweite Zeitintervall liegt dabei bevorzugt zeitlich nach dem ersten Zeitintervall und kann darauf entweder zeitlich direkt folgen, oder es kann ein zeitlicher Abstand zwischen den Zeitintervallen bestehen. Das erste Zeitintervall kann zu Beginn der Beschichtungsdauer liegen.

Die Zeitintervalle können kurz sein, bspw. wenige Minuten, oder länger, bis zu mehreren Stunden. Bspw. kann die Dauer des ersten und/oder des zweiten Zeitintervalls so gewählt sein, dass währenddessen die Schicht um einen geringen Betrag von bspw. 0,1 µm wächst, ebenso sind aber Ausführungen möglich, bei denen die Schicht während des ersten und/oder zweiten Zeitintervalls um bis zu 3µm wächst. Zur Erzielung von Einzellagen in der Schicht, deren Schichtdicke im Nanobereich, also bspw. 5 - 100nm, bevorzugt 5 - 50nm liegt, können die Zeitintervalle sehr kurz gewählt werden, bspw. 20 - 360, bevorzugt 20 - 180 Sekunden. Zur Erzielung von Einzellagen im Mikrobereich, also bspw. von 0,5 - 10µm, bevorzugt 0,5 - 2µm können die Zeitintervalle bspw. im Bereich von 50 - 1200 Minuten, bevorzugt 50 - 360 Minuten gewählt werden.

Beispielsweise kann eine der Verzögerungszeiten in einem Bereich liegen, in dem ein relativ höherer Anteil an Metallionen und relativ dazu geringerer Anteil an Gasionen im Plasma vorhanden ist, bspw. 30 - 80 µs, während die andere Verzögerungszeit so gewählt sein kann, dass ein relativ hoher Anteil an Gasionen im Plasma vorhanden ist, bspw. 0 - 20 µs oder mehr als 90 µs. Beispielsweise kann die Verzögerungszeit im ersten, zeitlich innerhalb der Beschichtungsdauer früheren Zeitintervall kürzer sein, so dass ein größerer Anteil an Metallionen zur Bildung der Schicht genutzt wird, während die Verzögerungszeit im zweiten, zeitlich innerhalb der Beschichtungsdauer späteren Zeitintervall länger ist, so dass ein höherer Anteil an Gasionen in die Schicht integriert wird.

Bevorzugt werden somit während mindestens eines Zeitabschnitts oder während der gesamten Beschichtungsdauer synchronisierte Bias-Pulse mit Verzögerungszeiten gegenüber den Kathodenpulsen erzeugt, wobei die Verzögerungszeiten variieren. Die Variation der Verzögerungszeiten kann dabei abrupt in Stufen oder auch (quasi-)kontinuierlich erfolgen.

Zur Bildung einer Übergangsschicht mit allmählicher Änderung der Schichteigenschaften kann die Variation der Verzögerungszeiten während eines Übergangs-Zeitintervalls, das einen Abschnitt oder die gesamte Beschichtungsdauer umfassen kann, bspw. stufenförmig oder kontinuierlich von einem ersten Wert auf einen zweiten Wert erfolgen, wobei der erste Wert höher oder geringer ist als der zweite Wert. Der Verlauf kann bspw. linear in Form einer Rampe sein, ebenso sind aber auch abweichende Verläufe möglich. Die Dauer des Übergangs-Zeitintervalls, währenddessen die Änderung erfolgt, kann so gewählt sein, dass währenddessen die Schicht um 0,5 µm - 20 µm wächst.

In weiteren bevorzugten Ausführungsformen kann die Variation über einen Abschnitt oder die gesamte Beschichtungsdauer stufenförmig oder kontinuierlich zwischen zwei Werten pendeln, so dass z.B. eine Multilayer-Struktur in der Schicht entsteht, bevorzugt mit mehr als 2 Einzellagen. Dabei kann die Verzögerungszeit während eines ersten Wechsel-Teilintervalls einen ersten Wert annehmen und während eines zweiten Wechsel-Teilintervalls einen zweiten, davon abweichenden Wert. Während eines Wechsel-Zeitintervalls können erste und zweite Wechsel-Teilintervalle ein- oder mehrfach aufeinander folgen. Dabei kann die Dauer des ersten und/oder des zweiten Wechsel-Teilintervalls jeweils so gewählt sein, dass währenddessen die Schicht um 5 nm - 2 µm wächst. Bevorzugte Beispiele sind für eine nanolagige Struktur eine Dicke jeder Einzellage von bspw. 5 - 100, bevorzugt 5 - 50 nm und für eine multilagige Struktur eine Dicke jeder Einzellage im Bereich von bspw. 0,1 - 2µm, bspw. bei 6 - 40 insgesamt in der Schicht vorhandenen Einzellagen.

Weitere bevorzugte Ausführungen betreffen die erfindungsgemäße Vorrichtung. So umfasst die Vorrichtung bevorzugt eine oder mehrere HIPIMS-Kathoden, d.h. Kathoden, die an eine HIPIMS-Leistungsversorgung angeschlossen sind. Die HIPIMS-Leistungsversorgung umfasst bevorzugt eine Kapazität zur Lieferung der elektrischen Leistung für HIPIMS-Pulse sowie eine Ladevorrichtung für die Kapazität. Die Leistungsversorgung ist bevorzugt leistungsgeregelt. Mehrere in der Vakuumkammer angeordnete Kathoden können mit Targets unterschiedlicher Zusammensetzung bestückt sein. So ist es möglich, durch Zu- oder Abschalten (bzw. Erhöhung/Verringerung der Leistung) der zugehörigen Leistungsversorgungen in einem durchgehenden Prozess ohne Vakuumunterbrechung Schichtlagen verschiedener Zusammensetzung aufeinander abzuscheiden. Dies erfolgt bevorzugt durch die Steuerung.

Nachfolgend werden Ausführungsformen anhand von Zeichnungen näher beschrieben. Dabei zeigen
- Fig. 1: eine schematische Darstellung einer Beschichtungsanlage mit elektrischer Beschaltung;
- Fig. 2: ein Diagramm mit Zeitablauf eines Kathodenpulses und eines Bias-Pulses;
- Fig. 3: ein Diagramm mit Darstellung der Menge und Art von Ionen im Plasma in zeitlicher Abfolge ab Auslösung eines Kathodenpulses;
- Fig. 4a - 4d: Diagramme zur zeitlichen Überdeckung verschiedener Zeitverläufe der Bias-Spannung mit Anzahl und Typ von Ionen im Plasma gem. Fig. 3;
- Fig. 5: in schematischer Darstellung eines Oberflächenbereichs eines beschich- teten Körpers ein Ausführungsbeispiel einer Beschichtung;
- Fig. 6a, 6b: als Zeitablaufdiagramm sowie in schematischer Darstellung eines Oberflächenbereichs eines beschichteten Körpers ein erstes Ausführungsbeispiel einer Beschichtung;
- Fig. 7a, 7b: als Zeitablaufdiagramm sowie in schematischer Darstellung eines Oberflächenbereichs eines beschichteten Körpers ein zweites Ausführungsbeispiel einer Beschichtung;
- Fig. 8a, 8b: als Zeitablaufdiagramm sowie in schematischer Darstellung eines Oberflächenbereichs eines beschichteten Körpers ein drittes Ausführungsbeispiel einer Beschichtung;
- Fig. 9a, 9b: als Zeitablaufdiagramm sowie in schematischer Darstellung eines Oberflächenbereichs eines beschichteten Körpers ein viertes Ausführungsbeispiel einer Beschichtung;
- Fig. 10a, 10b: als Zeitablaufdiagramm sowie in schematischer Darstellung eines Oberflächenbereichs eines beschichteten Körpers ein fünftes Ausführungsbeispiel einer Beschichtung;
- Fig. 11a, 11b: als Zeitablaufdiagramm sowie in schematischer Darstellung eines Oberflächenbereichs eines beschichteten Körpers ein sechstes Ausführungsbeispiel einer Beschichtung;
- Fig. 12: ein Ausführungsbeispiel eines Werkzeugs mit einer Beschichtung.

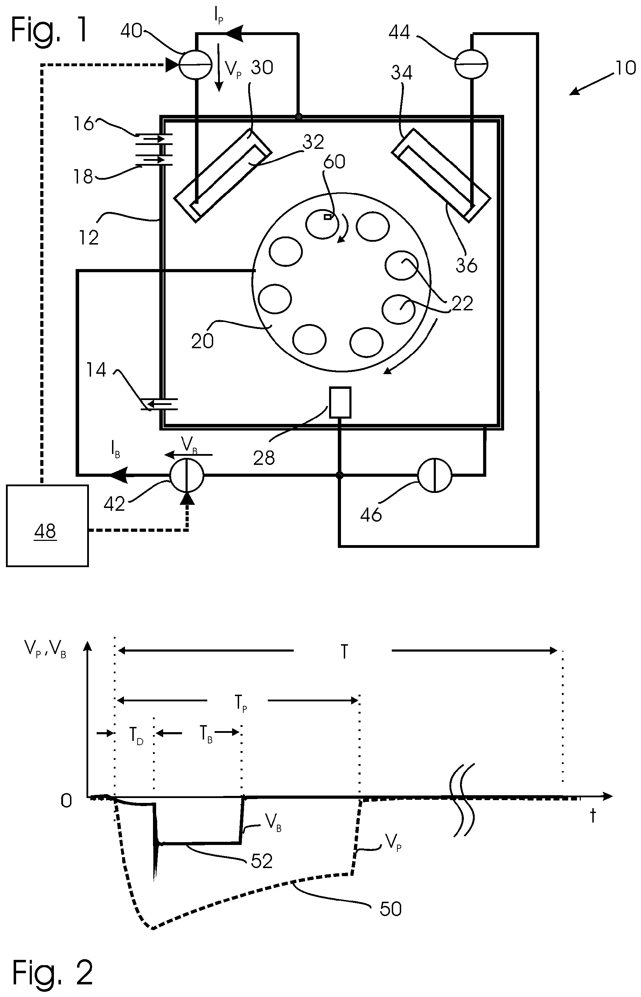

Figur 1 zeigt eine Beschichtungsanlage 10 in einer schematischen Darstellung. Die Beschichtungsanlage 10 umfasst eine hier schematisch von oben dargestellte Vakuumkammer 12 mit einem Vakuumsystem 14, durch das ein Vakuum im Inneren der Vakuumkammer 12 erzeugt werden kann. Die Vakuumkammer 12 weist ferner eine Prozessgaszuführung 16 und eine Reaktivgaszuführung 18 auf, mit der Prozessgas, im bevorzugten Beispiel Argon, und Reaktivgas, bspw. Stickstoff, in die Vakuumkammer 12 eingebracht werden können.

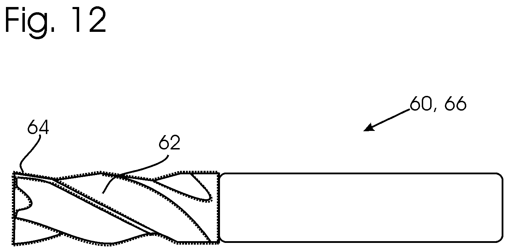

Innerhalb der Vakuumkammer 12 befindet sich ein rotierender Substrattisch 20 mit planetar rotierenden Substratträgern 22. Auf den Substratträgern 22 sind jeweils zu beschichtende Substrate 60, d.h. Grundkörper, bspw. von Werkzeugen (s. Fig. 12) angeordnet und elektrisch mit den Substratträger 22 und Substrattisch 20 kontaktiert. Innerhalb der Vakuumkammer 10 sind ferner Magnetron-Kathoden 30, 34 sowie eine Anode 28 angeordnet. Jede der Magnetron-Kathoden 30, 34 umfasst ein unbalanciertes Magnetsystem (nicht dargestellt) und ein plattenförmiges Sputter-Target 32, 36.

Die Magnetron-Kathoden 30,34, der Substrattisch 20 und die Anode 28 sind jeweils von außerhalb der Vakuumkammer 12 mittels elektrischer Durchführung durch die Wandung der Vakuumkammer 12 mit einer äußeren elektrischen Beschaltung der Beschichtungsanlage 10 verbunden.

Im gezeigten Beispiel ist die Magnetron-Kathode 34 als DC-Kathode beschaltet, d.h. mit einer DC-Leistungsversorgung 44 verbunden, die sie mit einer Gleichspannung gegenüber der Anode 28 beaufschlagt. Die Anode 28 ist mit einer Anoden-Leistungsversorgung 46 verbunden, die sie mit einer Gleichspannung gegenüber der leitenden Wandung der Vakuumkammer 12 beaufschlagt. Die Magnetron-Kathode 30 ist als HIPIMS-Kathode beschaltet, d.h. elektrisch verbunden mit einer HIPIMS-Leistungsversorgung 40, die sie mit einer gepulsten Spannung V_{P} gegenüber der Kammerwandung beaufschlagt. Der Substrattisch 20 ist mit einer Bias-Leistungsversorgung 42 verbunden, die ihn mit einer Bias-Spannung V_{B} gegenüber der Anode 28 beaufschlagt.

Die Beschichtungsanlage 10 ist mit einer Steuerung 48 ausgestattet, durch die die Bias-Leistungsversorgung 42 und die HIPIMS-Leistungsversorgung 40 gesteuert werden, wie im Einzelnen nachfolgend erläutert wird. Zudem steuert die Steuerung 48 den gesamten Prozess, d.h. auch das Vakuumsystem, den Drehantrieb des Substrattisches 20, die Zufuhr von Prozessgas und Reaktivgas sowie sämtliche weiteren elektrischen Leistungsversorgungen 44, 46. Die Steuerung ist programmierbar, d.h. sie umfasst einen Speicher für Beschichtungsprogramme, mit dem die nachfolgend erläuterten Abläufe und Verfahrensschritte vorgegeben werden.

Es ist anzumerken, dass die dargestellte elektrische Beschaltung und Bestückung der Beschichtungsanlage 10 mit Elektroden rein beispielhaft zu verstehen ist. In alternativen Ausführungen kann bspw. die HIPIMS-Kathode 30 gegenüber der Anode 28 geschaltet sein, oder es kann bspw. auf die Anode 28 verzichtet werden und die Kammerwand kann als Anode für alle Kathoden sowie für den Substrattisch 20 verschaltet sein. Es können mehrere oder auch keine DC-Kathoden 34 vorgesehen sein. Neben der HIPIMS-Kathode 30 können weitere HIPIMS-Kathoden in der Vakuumkammer 12 vorgesehen sein, jeweils verbunden mit einer eigenen HIPIMS-Leistungsversorgung. Die Kathoden 30, 34 können mit Targets 32, 36 gleicher oder unterschiedlicher Zusammensetzung bestückt werden.

Die HIPIMS-Leistungsversorgung 40 führt der HIPIMS-Kathode 30 elektrische Leistung gemäß dem HIPIMS-Verfahren zu, d.h. die zugeführte Spannung V_{P}, der Strom I_{P} und somit die elektrische Momentanleistung haben einen Zeitverlauf in Form von kurzen, sehr hohen Pulsen.

Beispielhaft ist eine Periodendauer T eines solchen periodischen Zeitverlaufs in Figur 2 dargestellt. Die an die HIPIMS-Kathode 30 angelegte Spannung V_{P} ist negativ. Der Zeitverlauf umfasst annähernd rechteckige Spannungspulse 50 einer Pulsdauer T_{P}. Für den Rest der Periodendauer T liegt keine Spannung an.

Nachfolgend werden beispielhaft bevorzugte Parameter des HIPIMS-Verfahrens genannt. Die Spannung V_{P} wird periodisch mit einer Frequenz von bspw. 100 - 10.000 Hz angelegt, bevorzugt 500 - 4000 Hz, so dass die Periodendauer T bevorzugt im Bereich von 250 - 2000 µs liegt. Die Pulsdauer T_{P} ist bevorzugt gering, bspw. kürzer als 200 µs, bevorzugt 40 - 100 µs. Bevorzugt liegt das Tastverhältnis T_{P}/T im Bereich von 1% bis 35%, bevorzugt bei 10 - 30%, besonders bevorzugt 20 - 28%. Der Betrieb der HIPIMS-Kathode(n) 30 erfolgt bevorzugt leistungsgeregelt, bspw. auf einen Wert von 3 - 20 kW pro HIPIMS-Kathode, bevorzugt 10 - 16 kW pro Kathode. Der sich während eines Pulses ergebene Peak-Strom liegt, bezogen auf die Vorderfläche des Targets 32, bevorzugt bei 0,4 - 2 A/cm², weiter bevorzugt bei 0,5 - 0,8 A/cm².

Im Betrieb der Beschichtungsanlage 10 zum Aufbringen einer Beschichtung 64 auf den Funktionsbereich 62 eines Substrats 60, wie beispielhaft in Figur 12 für einen Fräser 66 dargestellt, sind die zu beschichtenden Substrate 60 an den Substratträgern 22 innerhalb der Vakuumkammer 12 angeordnet. Im Inneren der Vakuumkammer 12 wird ein Vakuum erzeugt. Nach optionalen Vorbereitungsschritten (bspw. Heizen, Oberflächenbehandlung der Substrate 60 mittels Ionenätzen, Sputter-Cleaning der Kathoden 30, 34, etc.) wird durch Betrieb einer oder mehrerer HIPIMS-Kathoden 30 (sowie optional gleichzeitig einer oder mehrerer DC-Kathoden 34) unter Zerstäubung der Targets 32, 36 ein Plasma erzeugt. Bestandteile des Plasmas lagern sich auf der Oberfläche der Substrate 60 an und bilden die Schicht 64, wobei positiv geladene Ionen des Plasmas durch die negative Bias-Spannung V_{B} in Richtung auf die Substratoberfläche beschleunigt werden.

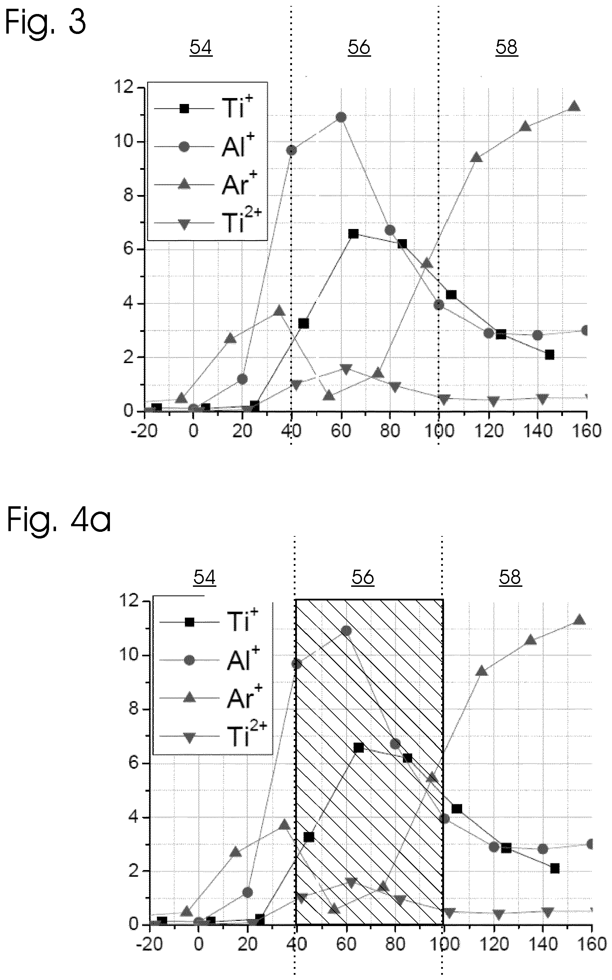

Figur 3 zeigt beispielhaft für eine HIPIMS-Kathode 30 mit einem Target 32 aus Titan und Aluminium sowie unter Zuführung von Argon als Prozessgas die im Plasma gemessenen Ionen in zeitlicher Auflösung nach Beginn eines Kathodenpulses 50 bei t=0 µs. Wie dargestellt enthält das Plasma verschiedene Spezies von Metall- und Gasionen, wobei allerdings die unterschiedlichen Spezies voneinander abweichende Zeitverläufe zeigen. So steigt die Anzahl der Argon-Ionen relativ schnell bis zu einem lokalen Maximum bei ca. 35 µs, fällt dann ab und steigt im späteren Verlauf ab ca. t=90 µs wieder deutlich an. Die Metall-Ionen steigen etwas langsamer an, erreichen ein Maximum etwa im Bereich von t=50-60 µs und fallen danach ab.

Es lassen sich wie schematisch dargestellt drei Zeitabschnitte 54, 56, 58 definieren, wobei im ersten Zeitabschnitt 54 (ca. 0-40 µs) Gas-Ionen vorherrschen, im darauf folgenden zweiten Zeitabschnitt 56 (von ca. 40-100 µs) die Metall-Ionen vorherrschen und im darauf folgenden dritten Zeitabschnitt 58 (ab ca. 100 µs) die Gasionen deutlich vorherrschen.

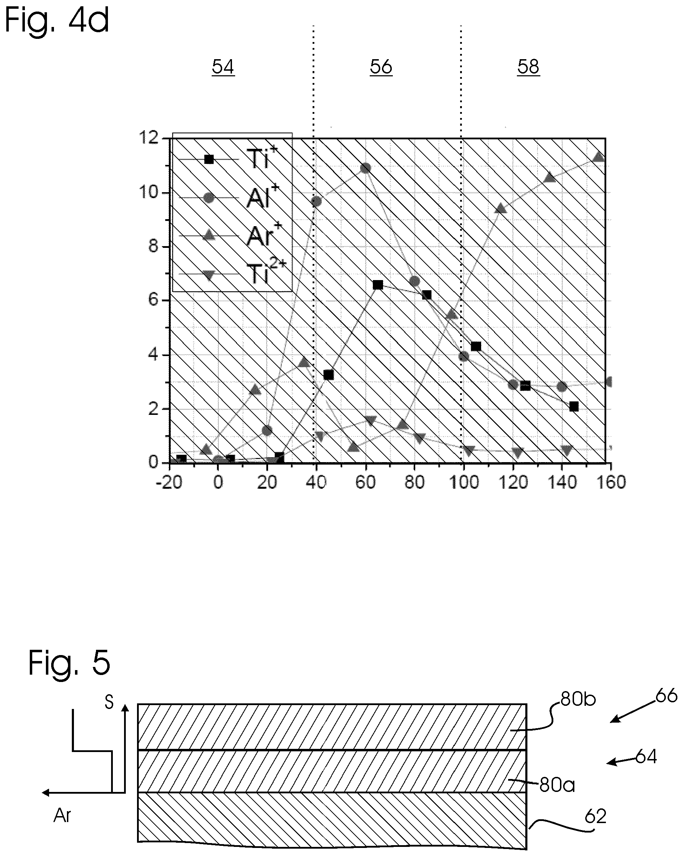

Durch die negative Bias-Spannung V_{B} werden die positiven Gas- und Metallionen des Plasmas in Richtung auf die Oberfläche des Substrats 60 beschleunigt und werden so Teil der sich dort anlagernden Beschichtung 64. Im Fall eines DC-Bias, d.h. einer durchgängigen Gleichspannung als Bias-Spannung V_{B} werden unterschiedslos alle Ionen für den Schichtaufbau ausgewählt. In Fig. 4d ist dies beispielhaft dargestellt, indem alle drei Zeitabschnitte 54, 56, 58, während derer die Bias-Spannung V_{B} gleichbleibend anliegt, schraffiert dargestellt sind.

Alternativ zu einem DC-Bias kann die Bias-Spannung V_{B} mit gepulstem Zeitverlauf, synchron zum Zeitverlauf der Spannung V_{P} an der HIPIMS-Kathode 30 angelegt werden. Ein solcher gepulster Zeitverlauf der Bias-Spannung V_{B} ist beispielhaft in Fig. 2 dargestellt. Die Bias-Spannung V_{B} weist einen Rechteckpuls 52 (Bias-Puls) auf, der während einer Bias-Pulsdauer T_{B} während des Kathodenpulses 50 anliegt. Dabei ist der Bias-Puls 52 gegenüber dem Kathodenpuls zeitlich um eine Verzögerungszeit T_{D} verzögert.

Durch geeignete Wahl der zeitlichen Synchronisation zwischen den Kathodenpulsen 50 und den Bias-Pulsen 52, d.h. insbesondere durch geeignete Auswahl der Bias-Pulsdauer T_{B} und der Verzögerungszeit T_{D}, kann unter den im Plasma zu verschiedenen Zeitpunkten vorhandenen Gas- und Metallionen eine Auswahl getroffen werden.

Bspw. ist in Fig. 4a der Effekt einer Vorgabe eines Zeitverlaufs der Bias-Pulse 52 mit einer Bias-Pulsdauer T_{B} von ca. 60µs und einer Verzögerungszeit T_{D} von ca. 40µs dargestellt. Der Bias-Puls 52 ist somit mit dem zweiten Zeitabschnitt 56 synchronisiert, in dem Metallionen vorherrschen. Durch Vorgabe eines solchen Zeitverlaufs der Bias-Spannung V_{B} wird so eine Beschichtung 64 mit sehr geringem Argon-Anteil erzeugt.

In Versuchen mit einem HIPIMS-Target 32 aus Titan, Silizium und Aluminium sowie unter Zuführung von Stickstoff als Reaktivgas zur Abscheidung einer Beschichtung 64 aus einem Ti-Al-Si-N Materialsystem ergab sich mit dem in Fig. 4a skizzierten Zeitverlauf der Bias-Spannung V_{B} ein Argon-Anteil von 0,03 at% in der Beschichtung 64. Die Beschichtung 64 wies eine Eigenspannung von -1,6 GPa und eine Härte von 26 GPa auf.

Im Vergleich hierzu zeigte sich bei sonst gleicher Konfiguration und Prozessführung bei Anlage eines DC-Bias (Fig. 4d) ein Argon-Anteil in der Beschichtung 64 von 0,12 at%, eine Eigenspannung von -5,3 GPa und eine Härte von 30GPa.

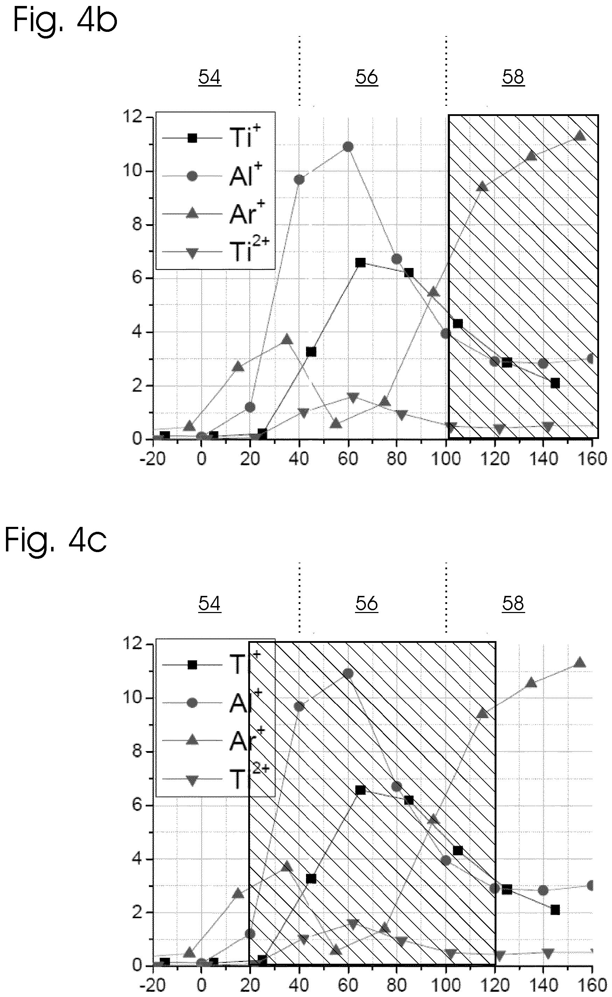

Als weiteres Beispiel eines möglichen Zeitverlaufs der Bias-Spannung V_{B} zeigt Fig. 4b einen Zeitverlauf mit einer Bias-Pulsdauer T_{B} von ca. 60µs und einer Verzögerungszeit T_{D} von ca. 100 µs, so dass der Bias-Puls 52 mit dem dritten Zeitabschnitt 58 synchronisiert ist, in dem Gasionen vorherrschen. Durch Vorgabe dieses Zeitverlaufs der Bias-Spannung V_{B} wird somit eine Beschichtung 64 mit hohem Argon-Anteil erzeugt.

Fig. 4c zeigt als weiteres Beispiel den Effekt eines Zeitverlaufs der Bias-Spannung V_{B} mit einer Bias-Pulsdauer T_{B} von ca. 100µs und einer Verzögerungszeit T_{D} von ca. 20 µs. Der Bias-Puls 52 überdeckt den zweiten Zeitabschnitt 56 vollständig und den ersten sowie dritten Zeitabschnitt 54, 58 jeweils teilweise. Durch Vorgabe dieses Zeitverlaufs der Bias-Spannung V_{B} wird eine Beschichtung 64 mit mittlerem Argon-Anteil erzeugt.

Somit ist durch Vorgabe des Zeitverlaufs der Bias-Spannung V_{B} möglich, die Schichtzusammensetzung zu beeinflussen und insbesondere den Argon-Anteil gezielt auf einen Wert zwischen einem minimalen Anteil (Fig. 4a) und einem maximalen Anteil (Fig. 4b) einzustellen.

Hierdurch werden die Schichteigenschaften erheblich beeinflusst, insbesondere die Eigenspannungen in der Beschichtung 64 sowie deren Härte.

Mittels der Beschichtungsanlage 10 werden auf die Substrate 60 jeweils Beschichtungen 64 aufgebracht. Diese wachsen mit fortschreitender Beschichtungsdauer d an, so dass sie ausgehend von der Oberfläche des Substrats 60 jeweils eine Dicke S aufweisen. Mittels der Steuerung 48 werden während der Beschichtungsdauer D sowohl die HIPIMS-Leistungsversorgung 40 als auch die Bias-Leistungsversorgung 42 angesteuert, so dass in verschiedenen Zeitintervallen während der Beschichtungsdauer D voneinander abweichende Zeitverläufe der Bias-Spannung V_{B} eingestellt werden können. So ergibt sich über die Schichtdicke S eine variierende Zusammensetzung der Beschichtung 64, nämlich abhängig vom jeweils eingestellten Zeitverlauf ein jeweils unterschiedlicher Argon-Anteil.

Der Zeitverlauf kann bei mit den Kathodenpulsen 50 synchronisierten Bias-Pulsen 52 (Fig. 2) charakterisiert werden durch die Verzögerungszeit T_{D} und Bias-Pulsdauer T_{B}. Beispielhaft kann davon die Bias-Pulsdauer T_{B} auf einen festen Wert von bspw. 60 µs eingestellt werden, während die Verzögerungszeit T_{D} abhängig von der Beschichtungsdauer D variiert.

Nachfolgend wird anhand von Fig. 5 ein Ausführungsbeispiel erläutert, bei dem durch einmalige Änderung der Synchronisation der Bias-Spannung VB während der Beschichtungsdauer eine zwei-lagige Beschichtung 64 auf einem Substrat 62 abgeschieden wird.

Zum Aufbringen der Beschichtung 64 wird zunächst der zu beschichtende Körper 60 aus Substratmaterial 62 am Substratträger 22 innerhalb der Vakuumkammer 12 positioniert, bspw. ein zweischneidiger Kugelkopffräser mit 6mm Durchmesser aus Hartmetall (WC/Co) mit 6at% Kobaltgehalt.

Die Beschichtungsanlage 10 wird bestückt mit vier HIPIMS-Kathoden 30, die rund um den Substrattisch 20 angeordnet werden. Je zwei nebeneinander angeordnete Kathoden 30 werden mit Targets 32 aus Titan-Aluminium Material (bspw. 60 at-% Ti, 40 at-% Al), die beiden übrigen mit Targets 32 aus Titan-Silizium Material (bspw. 80 at-% Ti, 20 at-% Si) bestückt.

Durch Betrieb des Vakuumsystems 14 wird ein Vakuum hergestellt. Das Innere der Vakuumkammer 12 wird aufgeheizt. Die Oberfläche des Substrats 60 wird durch ein Gasionenätzen unter Betrieb der Kathoden 30, 34 gereinigt. Die Targets 32, 36 werden durch Sputtercleaning vorbereitet.

Zu Beginn der Beschichtung wird zunächst in einem ersten Zeitintervall eine erste Lage 80a auf dem Substrat 60 abgeschieden. Dazu werden die beiden Kathoden 30 mit Al-Ti Targets betrieben mit je 12 kW Kathodenleistung, während die beiden übrigen Kathoden 30 mit Ti-Si Targets zunächst nicht betrieben werden. Die elektrische Leistung wird zugeführt in Form von HIPIMS Kathodenpulsen 50 mit einer Frequenz von 4000 Hz, Pulslänge 70µs. An das Substrat 60 wird dabei über den Substrattisch 20 und Substratträger 22 eine Biasspannung V_{B} angelegt. Die Biasspannung V_{B} ist gepulst mit Bias-Pulsen 52 von 60V und einer Bias-Pulsdauer T_{B} von 40µs, die synchron zu den Kathodenpulsen 50 sind, aber mit einer Verzögerungszeit T_{D} von 40µs auftreten.

Die erste Lage 80a wird abgeschieden mit einer Schichtrate von etwa 1 µm/h, so dass sie nach Dauer des ersten Zeitintervalls von 1,5 h eine Dicke von 1,5µm erreicht. Durch die gepulste Bias-Spannung V_{B} mit einer Verzögerungszeit T_{D} von 40µs werden gezielt Metallionen zur Bildung der Beschichtung 64 ausgewählt, während Argonionen, die erst im späteren zeitlichen Verlauf jedes Pulses vermehrt auftreten, nur in geringem Maße vorhanden sind (vgl. Fig. 4a). Der Argongehalt der Beschichtung 64 ist in der ersten Lage 80a kleiner oder gleich 0,03 at%, so dass sich Eigenspannungen von kleiner oder gleich - 1,6 GPa ergeben.

Nachfolgend wird in einem zweiten Zeitintervall auf die 1,5 µm dicke erste Lage 80a eine zweite Lage 80b abgeschieden. Dazu steuert die Steuerung 48 in der weiteren Ausführung des Beschichtungsprogramms die Leistungsversorgungen der beiden Kathoden 30 mit Ti-Si Targets so an, dass sie mit je 12 kW Kathodenleistung betrieben werden, während die beiden übrigen Kathoden 30 mit Al-Ti Targets nicht betrieben werden. Die HIPIMS-Parameter der elektrischen Leistungszuführung sind im zweiten Zeitintervall wie im ersten Zeitintervall, d.h. Frequenz von 4000 Hz, Pulslänge 70µs.

Allerdings wird beim Übergang von ersten zum zweiten Zeitintervall eine Variation des Zeitverlaufs der Bias-Spannung V_{B} derart vorgenommen, dass diese im zweiten Zeitintervall nicht mit gepulstem Zeitverlauf, sondern als dauerhafte Gleichspannung angelegt wird, so dass in erheblichem Umfang auch Argon-Ionen in der Beschichtung 64 enthalten sind.

Die zweite Lage 80b wird abgeschieden mit einer Schichtrate von etwa 1 µm/h, so dass sie nach Dauer des zweiten Zeitintervalls von 1,5 h eine Dicke von 1,5 µm erreicht. Durch die nicht gepulste Bias-Spannung V_{B} beträgt der Argongehalt der Beschichtung 64 in der zweiten Lage 80b mindestens 0,12 at%, so dass sich Eigenspannungen von mindestens 5,3 GPa ergeben.

Im Ergebnis ist die Beschichtung 64 2-lagig, wobei die erste Lage 80a durch die geringen Eigenspannungen und höhere Duktilität eine sehr gute Schichthaftung erreicht, während die äußere, zweite Lage 80b eine harte, glatte Oberfläche des beschichteten Körpers 60 gewährleistet. Der so beschichtete Kugelkopffräser ist geeignet für das Fräsen von hartem Stahl von mehr als 60 HRC ohne Emulsion.

Nachfolgend werden einzelne weitere Ausführungsbeispiele dargestellt, bei denen Beschichtungen 164, 264, 364, 464, 564, 664 auf dem Substrat 62 erzeugt werden, wobei jeweils durch Variation des Zeitverlaufs während der Beschichtungsdauer, insbesondere durch Änderung der Synchronisation der Bias-Spannung V_{B} die Zusammensetzung sowie die Eigenschaften der Beschichtungen geändert werden. Dabei wird in der folgenden Darstellung jeweils auf Nennung aller weiteren Details des Beschichtungsvorgangs verzichtet, bspw. der Target-Bestückung sowie der konkreten Parameter und Zeitdauern, da es vorrangig darum geht, prinzipielle Ausführungen zu zeigen, die auf verschiedene Materialsysteme und mit verschiedenen Parametern anwendbar sind.

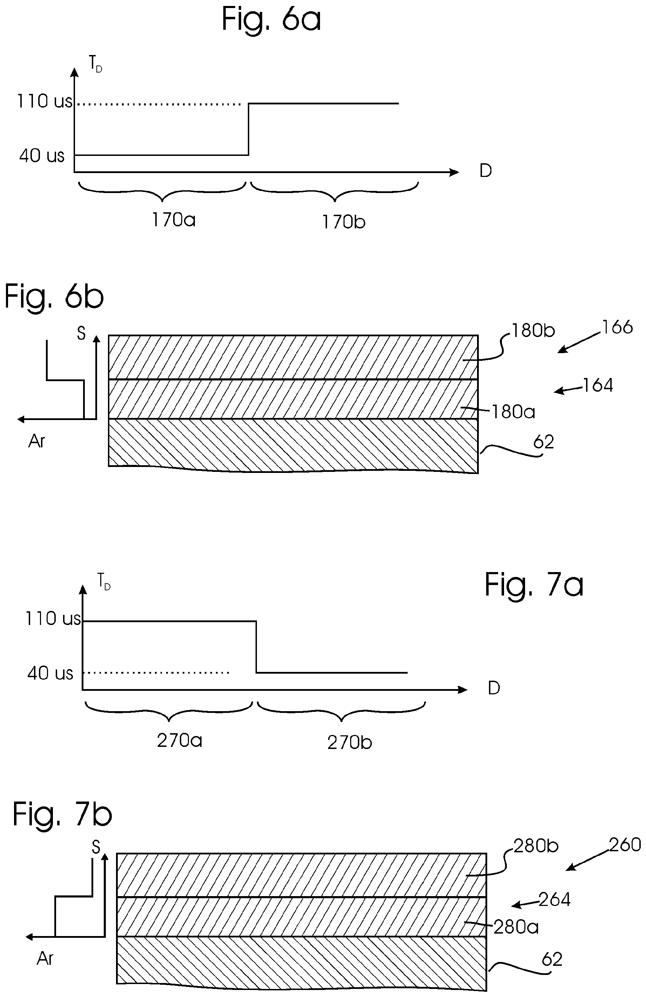

Fig. 6a, 6b zeigen ein erstes Ausführungsbeispiel eines beschichteten Körpers 166 mit einer 2-lagigen Beschichtung 164.

Bei Abscheidung der Beschichtung 164 wird die Bias-Spannung V_{B} jeweils mit gepulstem Zeitverlauf angelegt mit Bias-Pulsen 52, die zu den Kathodenpulsen 50 synchronisiert sind. Allerdings wird, wie in Fig. 6a gezeigt, die Synchronisation während der Beschichtungsdauer D geändert. So beträgt in einem ersten Zeitintervall 170a die Verzögerungszeit T_{D} zunächst 40µs und in einem darauffolgenden zweiten Zeitintervall 170b 110µs.

Fig. 6b zeigt schematisch einen Querschnitt durch einen entsprechend beschichteten Körper 166 mit der resultierenden Beschichtung 164 auf dem Substrat 62. Die Beschichtung 164 umfasst eine erste Lage 180a auf dem Substrat 62 mit geringem Argon-Anteil und eine darüberliegende zweite Lage 180b mit höherem Argon-Anteil. Die erste Lage 180a ist aufgrund des geringeren Argon-Anteils eher duktil und weist geringe Eigenspannungen auf, so dass sie als guter Haftvermittler zum Substrat 62 dienen kann. Die zweite, äußere Lage 180b hat aufgrund des höheren Argon-Anteils eine hohe Härte. Es hat sich gezeigt, dass eine solche Schicht sich besonders für Werkzeuge eignet, die für anspruchsvolle Zerspanungsanwendungen eingesetzt werden, bspw. für Bohr- und Fräswerkzeuge wie Schaftfräser, Kugelkopffräser und Wendeschneidplatten.

Fig. 7a, 7b zeigt schematisch ein zweites Ausführungsbeispiel mit gegenüber dem ersten Ausführungsbeispiel im Wesentlichen gegensätzlicher Prozessführung. Beim zweiten Ausführungsbeispiel wird die Verzögerungszeit T_{D} von zunächst 110µs in einem ersten Zeitintervall 270a geändert auf 40µs in einem darauffolgenden zweiten Zeitintervall 270b. Eine resultierende Beschichtung 264 des beschichteten Körpers 260 weist eine erste Lage 280a mit hohem Argon-Anteil und eine zweite Lange 280b mit geringerem Argon-Anteil auf.

Eine solche Beschichtung 264 kann vorteilhaft sein vor allem für beschichtete Körper 260, die für tribologische Anwendungen vorgesehen sind. Die erste Lage 280b dient als harte Grundschicht mit Eigenspannungen. Die zweite Lage 280b dient als Decklage darüber, die aufgrund der höheren Duktilität gute Einlaufeigenschaften hat. Mögliche Anwendungen können u.a. Gewindebohrer, Gewindeformer, Bohrer, Stech- und Stanzwerkzeuge sein.

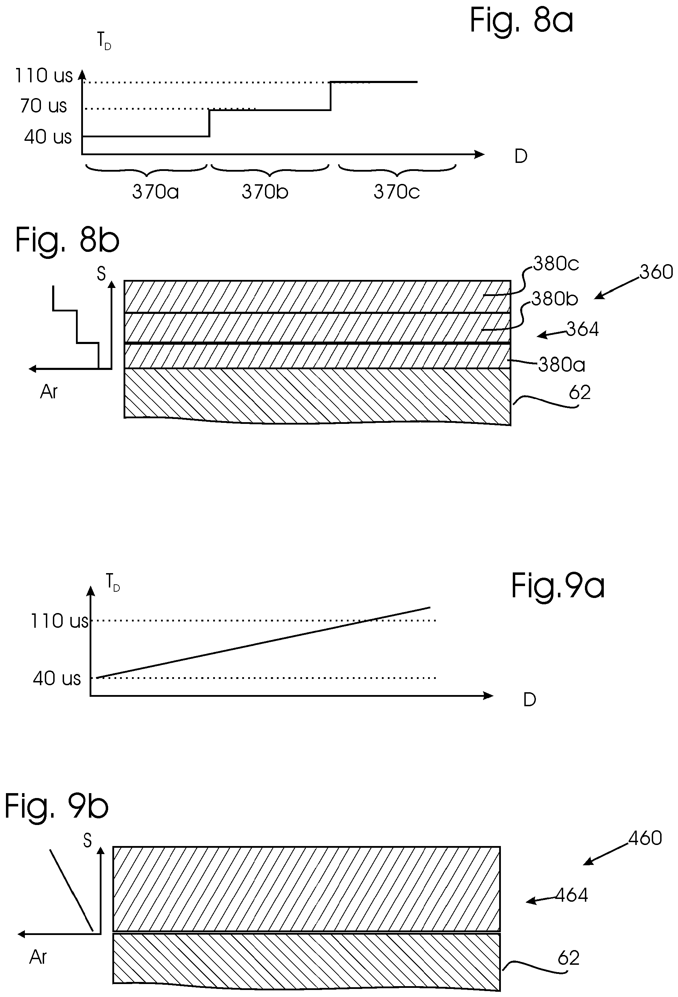

Fig. 8a, 8b zeigt schematisch ein drittes Ausführungsbeispiel. Das dritte Ausführungsbeispiel zeigt einen in drei Zeitintervallen 370a, 370b, 370c stufenweise variierenden Verlauf der Verzögerungszeit T_{D} über die Beschichtungsdauer D. Dabei steigt die Verzögerungszeit T_{D} wie beim ersten Ausführungsbeispiel stufenweise an. Eine resultierende Beschichtung 364 des beschichteten Körpers 360 weist eine erste Lage 380a mit geringem Argon-Anteil, eine zweite Lange 380b mit mittlerem Argon-Anteil und eine dritte, äußere Lange 380c mit hohem Argon-Anteil auf.

Fig. 9a, 9b zeigen ein viertes Ausführungsbeispiel, bei dem sich die Verzögerungszeit T_{D} und somit auch der Argon-Gehalt über die Beschichtungsdauer nicht stufenweise, sondern graduell ändert, hier beispielsweise in Form einer linear ansteigenden Rampe. Die so erzeugte Beschichtung 464 des beschichteten Körpers 460 zeigt entsprechend einen vom Substrat 62 in Richtung der Oberfläche ansteigenden Argon-Gehalt. Die Beschichtung 464 weist somit im Interface-Bereich zum Substrat 62 nur geringe Eigenspannungen auf, was die Haftung begünstigt. Im Bereich der Oberfläche weist die Beschichtung 464 hohe Härte auf, so dass insbesondere für Werkzeuge für Zerspanungsanwendungen vorteilhaft ist.

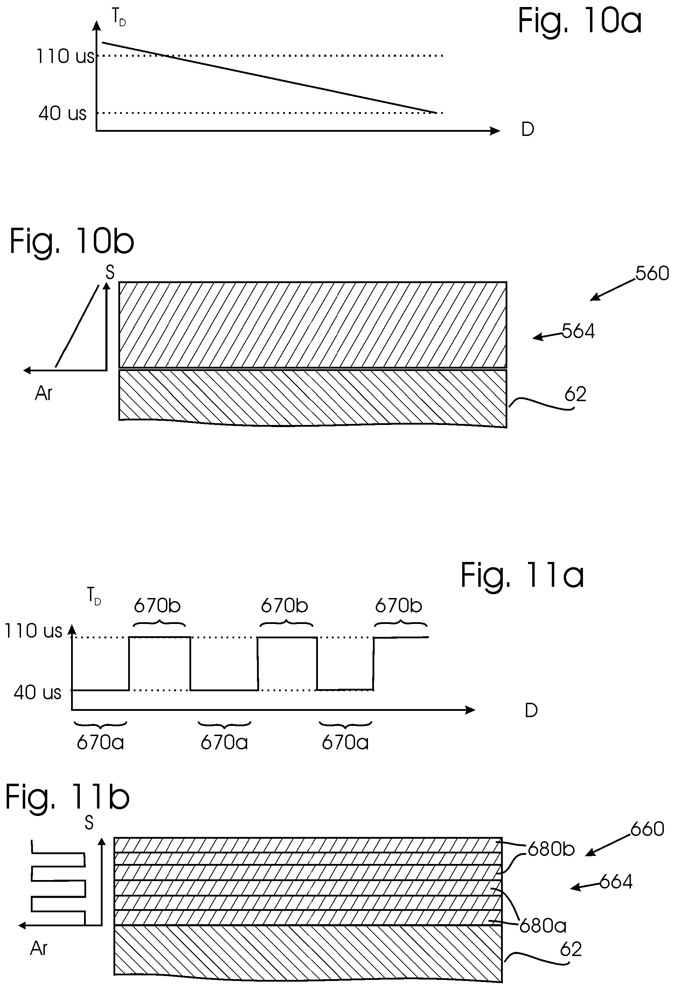

In Fig. 10a, 10b ist ein fünftes Ausführungsbeispiel mit gegenüber dem vierten Ausführungsbeispiel gegensätzlicher Prozessführung dargestellt, d.h. die Verzögerungszeit T_{D} und der Argon-Gehalt in der Beschichtung 564 des beschichteten Körpers 560 werden über die Beschichtungsdauer D stets geringer, hier in Form einer linear abfallenden Rampe.

Fig. 11a, 11b zeigen ein sechstes Ausführungsbeispiel, bei dem die Verzögerungszeit T_{D} in während der Beschichtungsdauer D wiederholt aufeinanderfolgenden ersten Zeitintervallen 670a und zweiten Zeitintervallen 670b sprunghaft ändert. Während der ersten Zeitintervalle 670a beträgt die Verzögerungszeit T_{D} 40µs und während der zweiten Zeitintervalle 670b beträgt die Verzögerungszeit T_{D} 110µs.

Die resultierende Beschichtung 664 des beschichteten Körpers 660 weist in der Folge in Richtung der Schichtdicke S abwechselnd aufeinanderfolgende erste Lagen 680a mit geringem Argon-Gehalt und zweite Lagen 680b mit höherem Argon-Gehalt auf. Die unmittelbar am Substrat 62 im Interface-Bereich angeordnete Lage ist eine erste Lage 680a mit geringen Eigenspannungen auf, was die Haftung begünstigt. Die äußerste Lage im Bereich der Oberfläche ist eine zweite Lage 680b von hoher Härte.

Die Dicke der Lagen 680a, 680b wird bei konstanter Schichtrate durch die Dauer der Zeitintervalle 670a, 670b vorgegeben. Durch entsprechende Wahl der Zeitdauern der Zeitintervalle 670a, 670b und der Anzahl der Wechsel können bspw. mehrlagige Beschichtungen 664 mit einer Dicke der Einzellagen 680a, 680b von z.B. 0,1 - 2 µm erzeugt werden. Ebenso kann durch schnelleren Wechsel der Zeitintervalle 670a, 670b eine nanolagige Beschichtung 664 mit einer Dicke der Einzellagen 680a, 680b von z.B. 5 - 50 nm erzeugt werden.

Die nachfolgende Tabelle 1 zeigt weitere Ausführungsbeispiele von Beschichtungen:

| Nr. | Schichtmaterial | Schichtaufbau | Verlauf der Ar-Konzentration über die Schichtdicke | Schichtdicke |
|---|---|---|---|---|
| 1 | Al-Ti-N | Monolagig, gradiert | Rampenartiger Anstieg bis zur Oberfläche | 0,5 - 20 µm |
| 2 | Ti-B₂ | Monolagig, gradiert | Rampenartiger Anstieg bis zur Oberfläche | 0,5 - 5 µm |
| 3 | Ti-C-N | Monolagig, gradiert | Rampenartiger Abfall bis zur Oberfläche | 0,5 - 3 µm |
| 4 | Ti-N | Monolagig, gradiert | Rampenartiger Anstieg bis zur Oberfläche | 0,1 - 2 µm |
| 5 | 1. Lage Al-Ti-N | 2-lagig, stufig | Stufig abfallend: 1. Lage viel Argon, 2. Lage wenig Argon | 1. Lage 0,5-3 µm |
| | 2. Lage Ti-Al-C-N | | | |
| | | | | 2. Lage 0,1-1,5 µm |
| 6 | 1. Lage Al-Ti-N | 2-lagig, stufig | Stufig abfallend: 1. Lage viel Argon, 2. Lage wenig Argon | 1. Lage 0,5-3 µm |
| | 2. Lage Ti-C-N | | | |
| | | | | 2. Lage 0,1-1,5 µm |
| 7 | 1. Lage Al-Ti-N | 2-lagig, stufig | Stufig abfallend: 1. Lage viel Argon, 2. Lage wenig Argon | 1. Lage 0,5-3 µm |
| | 2. Lage Ti-C | | | |
| | | | | 2. Lage 0,1-1,5 µm |
| 8 | Wie Beispiel 5, 6 oder 7 | 2-lagig, stufig, gradierter Übergang | Gradiert abfallend: 1. Lage viel Argon, 2. Lage gradierte Reduzierung auf weniger Argon | 1. Lage 0,5-3 µm |
| | | | | 2. Lage 0,1-1,5 µm |
| 9 | 1. Lage Al-Ti-N | 2-lagig, stufig | Stufig steigend: 1. Lage wenig Argon, 2. Lage viel Argon | 1. Lage 0,5-10 µm |
| | 2. Lage Ti-Si-N | | | |
| | | | | 2. Lage 0,1-20 µm |
| 10 | 1. Lage Al-Ti-N | 2-lagig, stufig | Stufig steigend: 1. Lage wenig Argon, 2. Lage viel Argon | 1. Lage 0,5-10 µm |
| | 2. Lage Ti-Al-Si-N | | | |
| | | | | 2. Lage 0,1-20 µm |
| 11 | 1. Lage Al-Ti-N | 2-lagig, stufig | Stufig steigend: 1. Lage wenig Argon, 2. Lage viel Argon | 1. Lage 0,5-10 µm |
| | 2. Lage Ti-Al-Cr- | | | |
| | Si-N | | | 2. Lage 0,1-20 µm |
| 12 | 1. Lage Al-Ti-N | 2-lagig, stufig | Stufig steigend: 1. Lage wenig Argon, 2. Lage viel Argon | 1. Lage 0,5-10 µm |
| | 2. Lage Ti-N | | | |
| | | | | 2. Lage 0,1-2 µm |
| 13 | 1. Lage Al-Ti-N | 2-lagig, stufig | Stufig steigend: 1. Lage wenig Argon, 2. Lage viel Argon | 1. Lage 0,5-10 µm |
| | 2. Lage Zr-N | | | |
| | | | | 2. Lage 0,1-2 µm |
| 14 | 1. Lage Al-Ti-N | 2-lagig, stufig | Stufig steigend: 1. Lage wenig Argon, 2. Lage viel Argon | 1. Lage 0,5-10 µm |
| | 2. Ti-N oder Zr-N oder C | | | |
| | | | | 2. Lage 0,1-2 µm |
| 15 | 1. Lage Al-Ti-N | 2-lagig, stufig, gradierter Übergang | Gradiert ansteigend: 1. Lage wenig Argon, 2. Lage gradierter Anstieg bis zu höherem Argon-Gehalt | 1. Lage 0,5-10 µm |
| | 2. Lage Ti-Al-Cr-Si-N oder Ti-C-N oder Ti-C oder C | | | |
| | | | | 2. Lage 0,1- 2 µm |
| 16 | Wie Beispiele 5, 6, 7 oder 15 | Multilagig (mehr als 2 Lagen) | Abwechselnd Lagen mit höherem und geringerem Argon-Gehalt | Einzellagen je 0,5-2 µm |
| 17 | Wie Beispiele 5, 6, 7 oder 15 | Nanolagig | Abwechselnd Lagen mit höherem und geringerem Argon-Gehalt | Einzellagen je 5 - 50 nm |

Die Beschichtung gemäß Beispiel 1 kann bspw. auf Werkzeuge wie Fräser, Bohrer, Wendeschneidplatten o.Ä. aus Stahl, rostfreiem Stahl oder CrMo-Stahl als Substratmaterial aufgebracht werden. Es handelt sich um Standardschichten mit wenig Eigenspannungen im Interfacebereich und höheren Eigenspannungen zur Oberfläche hin.

Bei Beispiel 2 handelt es sich um Schichten für spezielle Anwendungen mit wenig Eigenspannungen im Interfacebereich und höheren Eigenspannungen zur Oberfläche hin (besonders glatte Schichten). Diese können bspw. auf Werkzeuge wie Fräser, Bohrer, Wendeschneidplatten zur Bearbeitung von Aluminium, Titan oder NE-Metallen aufgebracht werden. Mögliche Anwendungen sind anspruchsvolle Zerspananwendungen für spezielle Materialien, in denen Materialanhaftungen vermieden werden sollen, also glatte Schichten erforderlich sind.

Gemäß Beispiel 3 ist der Gehalt an Argon zu Beginn der Abscheidung hoch und wird zur Oberfläche hin reduziert. Derartige Schichten können für bspw. Gewindebohrer, Gewindeformer, Bohrer oder Stech- und Stanzwerkzeuge verwendet werden. Als Substratmaterial kann bspw. Stahl, rostfreiem Stahl oder CrMo-Stahl dienen. Die Schichten sind gekennzeichnet durch eine harte Grundschicht mit höheren Eigenspannungen und eine weiche Decklage mit guten Einlaufeigenschaften und geringen Eigenspannungen. Mögliche Anwendungen von Werkzeugen mit solchen Schichten sind insbesondere tribologische Anwendungen.

Bei Beispiel 4 erfolgt eine gradierte Steigerung des Gehalts an Argon hin zur Oberfläche der Beschichtung, so dass diese glatt und optisch ansprechend ist. Derartige Schichten können Verwendung finden für alle Arten von Zerspanwerkzeugen und alle Arten von Substratwerkstoffen. Mögliche Anwendungen sind bspw. dekorativer Art. Eine Farbdecklage kann in einem separaten Prozess aufgebracht werden.

Die Schichten gemäß den Beispielen 5, 6 und 7 sehen einerseits eine veränderte Zusammensetzung der aufeinanderfolgenden Lagen und andererseits eine Veränderung des Argon-Gehalts vor. Dies kann bspw. erzielt werden, indem verschiedene HIPIMS-Magnetron-Kathoden in der Vakuumkammer mit Targets aus unterschiedlichen Materialien bestückt und separat voneinander angesteuert werden. Durch Abschaltung der Leistungsversorgung einer ersten Kathode, die bspw. mit einem Al-Ti-Target bestückt ist und gleichzeitiges Einschalten der Leistungsversorgung einer zweiten Kathode, die mit einem Ti-C-Target bestückt ist, kann bspw. der Wechsel von der ersten zur zweiten Lage im Beispiel 5 erfolgen. Das Ein- und Ausschalten der entsprechend bestückten Kathoden kann dabei sprunghaft oder in Form einer kurzen Rampe allmählich erfolgen.

Bei Beispiel 6 ist eine erste Kathode mit einem Al-Ti Target bestückt und eine zweite Kathode mit einem Ti-C Target; beim Lagenwechsel wird zwischen den Kathoden umgeschaltet.

Bei Beispiel 7 ist die zweite Kathode mit einem Ti-C-Target bestückt und es wird bei Beginn der Abscheidung der zweiten Lage die Zufuhr von Stickstoff als Reaktivgas abgeschaltet.

In allen drei Beispielen 5, 6 und 7 wird der Argongehalt zu Beginn der zweiten Lage sprunghaft reduziert. Die so erzeugten Schichten können bspw. auf Werkzeuge wie Gewindebohrer, Gewindeformer, Bohrer, Stech-und Stanzwerkzeuge aufgebracht werden aus Substratmaterialien wie Stahl, rostfreiem Stahl oder CrMo-Stahl. Anwendungen sind bspw. tribologische Anwendungen, für die es günstig ist, dass die erzeugten Schichten eine harte Grundschicht mit Eigenspannungen und eine weichere Decklage mit guten Einlaufeigenschaften und wenig Eigenspannungen aufweisen.

Die Schicht gemäß Beispiel 8 kann für dieselben Typen von Werkzeugen, Substratmaterialien und Anwendungen Verwendung finden wie gemäß den Beispielen 5, 6 und 7. Im Gegensatz zur dort sprunghaften, gestuften Reduzierung des Argon-Gehalts während der Beschichtungsdauer wird gemäß Beispiel 8 der Argongehalt allmählich, d.h. in Form einer Rampe reduziert.

Die Schichten gemäß den Beispielen 9, 10 und 11 sehen ebenfalls eine veränderte Zusammensetzung der Lagen vor, die durch Kathoden mit unterschiedlicher Bestückung an Targets und entsprechend geänderte elektrische Ansteuerung erreicht wird. Die Schichten können bspw. auf Werkzeuge wie Schaftfräser, Kugelkopffräser, Bohrer oder Wendeschneidplatten aus Substratmaterialien wie hartem Stahl, Ni-Basislegierungen, Titanlegierungen oder rostfreiem Stahl aufgebracht werden. Mögliche Anwendungen der resultierenden Schichten, die hart und glatt sind (Eigenschaft der zweiten Lage als Funktionsschicht mit hohem Argon-Gehalt) und gute Haftung aufweisen (Eigenschaft der ersten Lage, die mit geringem Argon-Gehalt als Haftvermittler dient), sind insbesondere anspruchsvolle Zerspananwendungen.

Beispiele 12, 13 und 14 können für Anwendungen dienen wie bspw. dekorative Schichten auf allen Arten von Funktionsschichten bzw. Schichten zur besseren Verschleißerkennung. Solche Schichten können somit bspw. in einem kombinierten Verfahren auf andere Schichten als oberer Abschluss aufgebracht werden. Als Substrate kommen alle Arten von Zerspanwerkzeugen in Frage, bspw. aus Stahl, Guss, CrMo-Stahl oder rostfreiem Stahl. Die untere Lage dient als Funktionsschicht und die obere Lage als dekorative Farbschicht von bspw. goldener Farbe, was eine gute Verschleißerkennung ermöglicht.

Beispiel 15 stellt mit einem gradierten Übergang des Argon-Gehalts eine Alternative für dieselben Anwendungen und Substrate dar wie die Beispiele 12, 13 und 14. In der genannten Variante mit einer zweiten Lage aus Kohlenstoff (C) wird eine graue Deckschicht erzeugt, die eine einfache optische Verschleißerkennung ermöglicht.

Bei den multilagigen Schichten gemäß Beispiel 16 sowie den nanolagigen Schichten gemäß Beispiel 17 wechseln sich jeweils Lagen mit hohem Argon-Gehalt (d.h. hohe Härte, hohe Eigenspannungen) ab mit solchen mit geringem Argon-Gehalt. Durch den stetigen Wechsel wird Rissbildung unterbunden und geringe Eigenspannungen des Gesamtsystems erreicht. Solche Schichten können für alle Arten von Zerspanwerkzeugen und für Substratmaterialien wie Stahl, insbesondere rostfreier Stahl, Hartstahl, CrMo, Ni-Basislegierungen, Titanlegierungen vorgesehen sein.

Zusammenfassend kann die Erfindung durch verschiedene Beschichtungsverfahren, Beschichtungsvorrichtungen und resultierende beschichtete Körper realisiert werden, wobei die einzelnen Ausführungsformen jeweils spezifisch Vorteile für verschiedene Anwendungen bieten. Dabei stellen die hier im einzelnen genannten Ausführungsformen jeweils Beispiele dar und sind illustrativ und nicht einschränkend zu verstehen. Zu den gezeigten Ausführungsformen sind verschiedene Änderungen und Alternativen möglich. Beispielsweise können die o.g. Ausführungsformen mit den verschiedensten Schichtmaterialien realisiert werden, d.h. mit abweichender Target-Bestückung sowie unter Zuführung von verschiedenen Reaktivgasen oder auch ohne Zuführung von Reaktivgas. Der Vorteil bleibt stets, dass die resultierenden Beschichtungen durch gezielte Einstellung von Eigenschaften in verschiedenen Schichtbereichen für die jeweiligen Anwendungen optimiert werden können.

## Patentansprüche

1. Verfahren zum Aufbringen einer Schicht (64) auf einen Körper (60), umfassend
- Anordnen des Körpers (60) in einer Vakuumkammer (12),
- Zuführung eines Prozessgases in die Vakuumkammer (12),
- Erzeugung eines Plasmas in der Vakuumkammer (12) durch Betrieb mindestens einer Kathode (30) durch Anlegen einer Kathodenspannung (V_{P}) mit Kathodenpulsen (50) und Zerstäuben eines Targets (32),
- Anlegen einer Bias-Spannung (V_{B}) an den Körper (60), so dass Ladungsträger des Plasmas in Richtung des Körpers (60) beschleunigt werden und sich während einer Beschichtungsdauer (D) auf dessen Oberfläche anlagern,
- wobei ein Zeitverlauf der Bias-Spannung (V_{B}) während mindestens eines Teils der Beschichtungsdauer (D) Bias-Pulse (52) umfasst, wobei die Bias-Pulse (52) mit den Kathodenpulsen (50) synchronisiert sind,
**dadurch gekennzeichnet, dass**
- der Zeitverlauf der Bias-Spannung (V_{B}) während der Beschichtungsdauer (D) variiert durch eine Änderung der Dauer und/oder der Synchronisation der Bias-Pulse (52) gegenüber den Kathodenpulsen (50).

2. Verfahren nach Anspruch 1, bei dem
- ein Anteil des Prozessgases in der Schicht (64) abhängig ist vom Zeitverlauf der Bias-Spannung (V_{B}),
- und wobei durch Variation des Zeitverlaufs der Bias-Spannung (V_{B}) während der Beschichtungsdauer (D) ein Anteil an Prozessgas in der Schicht (64) variiert.

3. Verfahren nach einem der Ansprüche 1, 2, bei dem
- der Zeitverlauf der Bias-Spannung (V_{B}) mindestens während eines ersten Zeitintervalls Bias-Pulse (52) umfasst,
- und wobei die Bias-Spannung (V_{B}) mindestens während eines weiteren Zeitintervalls eine Gleichspannung ist.

4. Verfahren nach einem der vorangehenden Ansprüche, bei dem
- der Zeitverlauf der Bias-Spannung (V_{B}) mindestens während eines ersten Zeitintervalls (170a, 270a, 370a) Bias-Pulse (52) umfasst,
- wobei die Bias-Pulse (52) mit den Kathodenpulsen (50) synchronisiert sind,
- und wobei die Bias-Pulse (52) gegenüber den Kathodenpulsen (50) um eine Verzögerungszeit (T_{D}) verzögert auftreten.

5. Verfahren nach Anspruch 4, bei dem
- im ersten Zeitintervall (170a, 270a, 370a) die Bias-Pulse (52) gegenüber den Kathodenpulsen (50) um eine erste Verzögerungszeit (T_{D}) verzögert auftreten,
- und der Zeitverlauf der Bias-Spannung (V_{B}) mindestens während eines zweiten Zeitintervalls (170b, 270b, 370b) Bias-Pulse (52) umfasst, die mit den Kathodenpulsen (50) synchronisiert sind und gegenüber den Kathodenpulsen (50) um eine zweite Verzögerungszeit (T_{D}) verzögert auftreten,
- wobei sich die erste und die zweite Verzögerungszeit (T_{D}) unterscheiden.

6. Verfahren nach Anspruch 5, bei dem
- die Dauer des ersten Zeitintervalls (170a, 270a, 370a) und/oder des zweiten Zeitintervalls (170b, 270b, 370b) so gewählt ist, dass währenddessen die Schicht um 0,1 µm - 3 µm wächst.

7. Verfahren nach Anspruch 5 oder 6, bei dem
- das erste Zeitintervall (170a, 270a, 370a) innerhalb der Beschichtungsdauer (D) vor dem zweiten Zeitintervall (170b, 270b, 370b) liegt,
- und die Verzögerungszeit (T_{D}) im ersten Zeitintervall (170a, 270a, 370a) kürzer ist als im zweiten Zeitintervall (170b, 270b, 370b).

8. Verfahren nach Anspruch 7, bei dem
- das erste Zeitintervall (170a, 270a, 370a) zu Beginn der Beschichtungsdauer (D) liegt.

9. Verfahren nach einem der Ansprüche 4 - 8, bei dem
- sich die Verzögerungszeit (T_{D}) während eines Übergangs-Zeitintervalls in Stufen oder kontinuierlich von einem ersten Wert zu einem zweiten Wert ändert.

10. Verfahren nach Anspruch 9, bei dem
- die Dauer des Übergangs-Zeitintervalls so gewählt ist, dass währenddessen die Schicht um 0,5 µm - 20 µm wächst.

11. Verfahren nach einem der Ansprüche 4 - 10, bei dem
- während eines ersten Wechsel-Teilintervalls (670a) die Verzögerungszeit (T_{D}) einen ersten Wert beträgt und während eines zweiten Wechsel-Teilintervalls (670b) die Verzögerungszeit (T_{D}) einen zweiten Wert beträgt
- und während eines Wechsel-Zeitintervalls abwechselnd erste und zweite Wechsel-Teilintervalle (670a, 670b) aufeinander folgen.

12. Verfahren nach Anspruch 11, bei dem
- die Dauer des ersten und/oder des zweiten Wechsel-Teilintervalls jeweils so gewählt ist, dass währenddessen die Schicht um 5 nm - 500 nm wächst.

13. Verfahren nach einem der vorangehenden Ansprüche, bei dem
- die Kathode (30) durch Anlegen der Kathodenpulse (50) nach dem HIPIMS-Verfahren betrieben wird und das Prozessgas Argon ist.

14. Vorrichtung zum Aufbringen einer Schicht auf einen Körper, mit
- einer Vakuumkammer (12) mit einer Aufnahme (22) für den Körper (60), einer Prozessgaszuführung (16), und mindestens einer Kathode (30) mit einem Target (32),
- einer gepulsten Kathoden-Leistungsversorgung (40) zur Versorgung der Kathode (30) mit einer elektrischen Kathodenspannung (V_{P}) mit Kathodenpulsen (50),
- einer steuerbaren Bias-Leistungsversorgung (42) zum Anlegen einer Bias-Spannung (V_{B}) an den Körper (60)
- einer Steuerung (48) zur Ansteuerung der Bias-Leistungsversorgung (60) so, dass ein Zeitverlauf der Bias-Pulse (52) während mindestens eines Teils der einer Beschichtungsdauer (D) Bias-Pulse (52) umfasst, wobei die Bias-Pulse (52) mit den Kathodenpulsen (50) synchronisiert sind,
**dadurch gekennzeichnet, dass**
- der Zeitverlauf der Bias-Spannung (V_{B}) während der Beschichtungsdauer (D) variiert durch eine Änderung der Dauer und/oder der Synchronisation der Bias-Pulse (52) gegenüber den Kathodenpulsen (50).

## Claims

1. A method for applying a layer (64) to a body (60), comprising
- disposing the body (60) in a vacuum chamber (12),
- supplying a process gas into the vacuum chamber (12),
- generating a plasma in the vacuum chamber (12) by operating at least one cathode (30) by applying a cathode voltage (V_{P}) with cathode pulses (50) and sputtering a target (32),
- applying a bias voltage (V_{B}) to the body (60) so that charge carriers of the plasma are accelerated into the direction of the body (60) and attached to its surface during a coating duration (D),
- wherein a time course of the bias voltage (V_{B}) comprises bias pulses (52) during at least a part of the coating duration (D), wherein the bias pulses (52) are synchronized with the cathode pulses (50),
**characterized in that**
- the time course of the bias voltage (V_{B}) varies during the coating duration (D) by a change of the duration and/or the synchronization of the bias pulses (52) with respect to the cathode pulses (50).

2. The method according to claim 1, wherein
- a proportion of the process gas in the layer (64) is dependent on the time course of the bias voltage (V_{B}),
- and wherein, by variation of the time course of the bias voltage (V_{B}) during the coating duration (D), a proportion of process gas in the layer (64) varies.

3. The method according to one of claims 1, 2, wherein
- the time course of the bias voltage (V_{B}) comprises bias pulses (52) at least during a first time interval,
- and wherein the bias voltage (V_{B}) is a DC voltage at least during another time interval.

4. The method according to one of the preceding claims, wherein
- the time course of the bias voltage (V_{B}) comprises bias pulses (52) at least during a first time interval (170a, 270a, 370a),
- wherein the bias pulses (52) are synchronized with the cathode pulses (50),
- and wherein the bias pulses (52) occur delayed with respect to the cathode pulses (50) by a delay time (T_{D}).

5. The method according to claim 4, wherein
- during the first time interval (170a, 270a, 370a), the bias pulses (52) occur delayed with respect to the cathode pulses (50) by a first delay time (T_{D}),
- and the time course of the bias voltage (V_{B}) comprises, at least during a second time interval (170b, 270b, 370b), bias pulses (52) which are synchronized with the cathode pulses (50) and occur delayed with respect to the cathode pulses (50) by a second delay time (T_{D}),
- wherein the first and the second delay times (T_{D}) differ.

6. The method according to claim 5, wherein
- the duration of the first time interval (170a, 270a, 370a) and/or the second time interval (170b, 270b, 370b) is chosen so that, during it, the layer grows by 0.1 µm-3 µm.

7. The method according to claim 5 or 6, wherein
- the first time interval (170a, 270a, 370a) is before the second time interval (170b, 270b, 370b) within the coating duration (D),
- and the delay time (T_{D}) in the first time interval (170a, 270a, 370a) is shorter than in the second time interval (170b, 270b, 370b).

8. The method according to claim 7, wherein
- the first time interval (170a, 270a, 370a) is at the beginning of the coating duration (D).

9. The method according to one of claims 4 - 8, wherein
- the delay time (T_{D}) changes during a transition time interval in steps or continuously from a first value to a second value.

10. The method according to claim 9, wherein
- the duration of the transition time interval is chosen so that, during it, the layer grows by 0.5 µm-20 µm.

11. The method according to one of claims 4 - 10, wherein
- during a first switching subinterval (670a) the delay time (T_{D}) has a first value and during a second switching subinterval (670b) the delay time (T_{D}) has a second value
- and during a switching time interval, alternating first and second switching subintervals (670a, 670b) follow each other.

12. The method according to claim 11, wherein
- the duration of the first and/or of the second switching subinterval is each chosen so that, during this time, the layer grows by 5 nm -500 nm.

13. The method according to one of the preceding claims, wherein
- the cathode (30) is operated by applying the cathode pulses (50) according to the HIPIMS method and the process gas is argon.

14. A device for applying a layer to a body, with
- a vacuum chamber (12) with a carrier (22) for the body (60), a process gas supply (16), and at least one cathode (30) with a target (32),
- a pulsed cathode power supply (40) for supplying the cathode (30) with an electrical cathode voltage (V_{P}) with cathode pulses (50) during a coating duration (D),
- a controllable bias power supply (42) for applying a bias voltage (V_{B}) to the body (60)
- and a controller (48) for controlling the bias power supply (60) so that a time course of the bias voltage (V_{B}) comprises bias pulses (52) during at least a part of the coating duration (D), the bias pulses (52) being synchronized with the cathode pulses (50),
**characterized in that**
- the time course of the bias voltage (V_{B}) varies during the coating duration (D) by a change of the duration and/or the synchronization of the bias pulses (52) with respect to the cathode pulses (50).

## Revendications

1. Procédé pour appliquer une couche (64) sur un corps (60), comprenant
- disposition du corps (60) dans une chambre à vide (12),
- l'alimentation de la chambre à vide (12) en gaz de traitement,
- générer un plasma dans la chambre à vide (12) en actionnant au moins une cathode (30) en appliquant une tension cathodique (V_{P} ) avec des impulsions cathodiques (50) et en pulvérisant une cible (32),
- appliquer une tension de polarisation (V_{B} ) au corps (60) de manière à ce que les porteurs de charge du plasma soient accélérés dans la direction du corps (60) et se fixent à sa surface pendant une durée de revêtement (D),
- dans lequel une évolution temporelle de la tension de polarisation (V_{B} ) comprend des impulsions de polarisation (52) pendant au moins une partie de la durée de revêtement (D), les impulsions de polarisation (52) étant synchronisées avec les impulsions cathodiques (50),
**caractérisé en ce que**
- l'évolution dans le temps de l' de tension de polarisation (V_{B} ) varie pendant la durée de revêtement (D) par une modification de la durée et/ou de la synchronisation des impulsions de polarisation (52) par rapport aux impulsions cathodiques (50).

2. Procédé selon la revendication 1, dans lequel
- une proportion du gaz de traitement dans la couche (64) dépend de l'évolution dans le temps de la tension de polarisation (V_{B} ),
- et dans laquelle, par variation de l'évolution dans le temps de la tension de polarisation (V_{B} ) pendant la durée de revêtement (D), une proportion du gaz de traitement dans la couche (64) varie.

3. Procédé selon l'une des revendications 1 et 2, dans lequel
- l'évolution dans le temps de la tension de polarisation (V_{B} ) comprend des impulsions de polarisation (52) au moins pendant l' d'un premier intervalle de temps,
- et dans lequel la tension de polarisation (V_{B} ) est une tension continue au moins pendant un autre intervalle de temps.

4. Procédé selon l'une des revendications précédentes, dans lequel
- l'évolution dans le temps de la tension de polarisation (V_{B} ) comprend des impulsions de polarisation (52) au moins pendant un premier intervalle de temps (170a, 270a, 370a),
- les impulsions de polarisation (52) sont synchronisées avec les impulsions cathodiques (50),
- et dans lequel les impulsions de polarisation (52) se produisent avec un retard par rapport aux impulsions cathodiques (50) d'un temps de retard (T_{D} ).

5. Procédé selon la revendication 4, dans lequel
- pendant le premier intervalle de temps (170a, 270a, 370a), les impulsions de polarisation (52) se produisent avec un retard par rapport aux impulsions cathodiques (50) d'un premier temps de retard (T_{D} ),
- et l'évolution dans le temps de la tension de polarisation (V_{B} ) comprend, au moins pendant un deuxième intervalle de temps (170b, 270b, 370b), des impulsions de polarisation (52) qui sont synchronisées avec les impulsions cathodiques (50) et se produisent avec un retard par rapport aux impulsions cathodiques (50) d'un deuxième temps de retard (T_{D} ),
- les premier et deuxième temps de retard (T_{D} ) étant différents.

6. Procédé selon la revendication 5, dans lequel
- la durée du premier intervalle de temps (170a, 270a, 370a) et/ou du deuxième intervalle de temps (170b, 270b, 370b) est choisie de telle sorte que, pendant celui-ci, la couche croît de 0,1 µm à 3 µm.

7. Procédé selon la revendication 5 ou 6, dans lequel
- le premier intervalle de temps (170a, 270a, 370a) précède le deuxième intervalle de temps (170b, 270b, 370b) dans la durée de revêtement (D),
- et le temps de retard (T_{D} ) dans le premier intervalle de temps (170a, 270a, 370a) est plus court que dans le deuxième intervalle de temps (170b, 270b, 370b).

8. Procédé selon la revendication 7, dans lequel
- le premier intervalle de temps (170a, 270a, 370a) se situe au début de la durée de revêtement (D).

9. Procédé selon l'une des revendications 4 à 8, dans lequel
- le temps de retard (T_{D} ) change pendant un intervalle de temps de transition par paliers ou de manière continue d'une première valeur à une deuxième valeur.

10. Procédé selon la revendication 9, dans lequel
- la durée de l'intervalle de temps de transition est choisie de telle sorte que, pendant celui-ci, la couche croît de 0,5 µm à 20 µm.

11. Procédé selon l'une des revendications 4 à 10, dans lequel
- pendant un premier sous-intervalle de commutation (670a), le temps de retard (T_{D} ) a une première valeur et pendant un deuxième sous-intervalle de commutation (670b), le temps de retard (T_{D} ) a une deuxième valeur
- et pendant un intervalle de temps de commutation, les premier et deuxième sous-intervalles de commutation (670a, 670b) se succèdent en alternance.

12. Procédé selon la revendication 11, dans lequel
- la durée du premier et/ou du deuxième sous-intervalle de commutation est choisie de telle sorte que, pendant ce temps, la couche croît de 5 nm à 500 nm.

13. Procédé selon l'une des revendications précédentes, dans lequel
- la cathode (30) est actionnée en appliquant les impulsions cathodiques (50) selon le procédé HIPIMS et le gaz de traitement est de l'argon.

14. Dispositif pour appliquer une couche sur un corps, avec
- une chambre à vide (12) avec un support (22) pour le corps (60), une alimentation en gaz de traitement (16) et au moins une cathode (30) avec une cible (32),
- une alimentation électrique pulsée (40) pour cathode pour alimenter la cathode (30) avec une tension électrique (V_{P} ) avec des impulsions cathodiques (50) pendant une durée de revêtement (D),
- une alimentation électrique de polarisation contrôlable (42) pour appliquer une tension de polarisation (V_{B} ) au corps (60)
- et un contrôleur (48) pour contrôler l'alimentation de polarisation (60) de telle sorte qu'une évolution temporelle de la tension de polarisation (V_{B} ) comprenne des impulsions de polarisation (52) pendant au moins une partie de la durée de revêtement (D), les impulsions de polarisation (52) étant synchronisées avec les impulsions d' de cathode (50), **caractérisé en ce que**
- l'évolution dans le temps de la tension de polarisation (V_{B} ) varie pendant la durée de revêtement (D) par une modification de la durée et/ou de la synchronisation des impulsions de polarisation (52) par rapport aux impulsions cathodiques (50).
